# EUROPEAN PATENT APPLICATION

(11) **EP 4 475 146 A1**
(43) Date of publication of application: **11.12.2024**
(21) Application number: 23749472.9
(22) Date of filing: 06.01.2023
(51) Int. Cl.: H01F 1/26, C08L 101/00, H05K 1/16

(54) **MAGNETIC PASTE**

(30) Priority: 01.02.2022 JP 2022014316
(71) Applicant: AJINOMOTO CO., INC., Chuo-ku Tokyo 104-8315 (JP)
(72) Inventor: KANETAKA, Saori, Kawasaki-shi, Kanagawa 210-0801 (JP); TANAKA, Takayuki, Kawasaki-shi, Kanagawa 210-0801 (JP); HOMMA, Tatsuya, Kawasaki-shi, Kanagawa 210-0801 (JP)
(74) Representative: Mewburn Ellis LLP
(86) International application number: PCT/JP2023/000156
(87) International publication number: WO 2023/149155

(57) **Abstract**

A magnetic paste comprising: (A) a magnetic powder; and (B) a thermosetting resin, wherein (A) the magnetic powder has an average particle diameter of 10 µm or less, and a water content in the magnetic paste is 1000 ppm or less.

## Description

### Technical Field

The present invention relates to a magnetic paste and a production method thereof, a cured product using the magnetic paste, a circuit board and a production method thereof, and an inductor component.

### Background Art

As the demand for a smaller and thinner electronic device increases in recent years, a circuit board used in an electronic device is also required to be smaller in its size and higher in its wiring density. As for the circuit board like this, those that are formed by filling a through hole thereof with a paste material have been known.

For example, in Patent Literature 1, it is described that a through hole in the circuit board for an inductor component is filled with a magnetic paste containing a magnetic particle such as an iron (III) oxide and an iron cobalt oxide.

### Citation List

### Patent Literature

Patent Literature 1: Japanese Patent Application Laid-open No. 2016-197624

### Summary of the Invention

### Technical Problem

By filling the through hole with a magnetic paste followed by curing, a magnetic layer can be formed in the through hole. In order to improve a performance of the inductor component, the magnetic layer is required to have a high relative magnetic permeability and a low magnetic loss. In general, a larger particle diameter of a magnetic powder is advantageous for a higher magnetic permeability, but this tends to increase a magnetic loss. Therefore, in order to satisfy both a high relative magnetic permeability and a low magnetic loss, it is desirable that the magnetic paste includes a large amount of the magnetic powder that has a small particle diameter.

On the other hand, when the magnetic paste is filled in the hole by a filling method such as a printing method, it is required to control the filling condition thereof in accordance with a viscosity of the magnetic paste. However, the viscosity of the magnetic paste may change with passage of time. In the case where the viscosity of the magnetic paste changes with passage of time, the filling condition is required to be changed each time when the viscosity changes. As a result of the study made by the inventor of the present invention, it has been found that, in the case where the magnetic powder having a small particle diameter is used, increase in the viscosity of the magnetic paste with passage of time tends to be large, so that the problem of the viscosity change with passage of time has emerged. The large increase in the viscosity results in a poor filling property, which in turn may cause a decrease in a yield and a productivity.

The present invention has been devised in view of the problem described above, and thus has an object to provide: a magnetic paste having a small viscosity change with passage of time while a magnetic powder having a small particle diameter is included therein, and a production method of the magnetic paste; a cured product of the magnetic paste; a circuit board containing the cured product of the magnetic paste and a production method of the circuit board; and an inductor component comprising the circuit board.

### Solution to Problem

The inventor of the present invention has extensively studied how to solve the problem described above. As a result, the inventor has found that it is possible to solve the problem described above by the magnetic paste that includes (A) a magnetic powder having a small particle diameter and (B) a thermosetting resin, and that has a specific range of a water content. On the basis of this finding, the present invention has been completed. Namely, the present invention includes the following aspects.
<1> A magnetic paste comprising:
   (A) a magnetic powder; and
   (B) a thermosetting resin, wherein
   (A) the magnetic powder has an average particle diameter of 10 um or less, and
   a water content in the magnetic paste is 1000 ppm or less.
<2> The magnetic paste according to <1>, wherein an amount of (A) the magnetic powder relative to 100% by volume of nonvolatile components in the magnetic paste is 30% by volume or more.
<3> The magnetic paste according to <1> or <2>, wherein (B) the thermosetting resin comprises (B-1) an epoxy resin.
<4> The magnetic paste according to <3>, wherein an amount of (B-1) the epoxy resin relative to 100% by mass of resin components in the magnetic paste is 30% by mass or more.
<5> The magnetic paste according to any one of <1> to <4>, comprising (C) a curing accelerator.
<6> The magnetic paste according to any one of <1> to <5>, wherein the magnetic paste is for filling a through hole.
<7> A cured product of the magnetic paste according to any one of <1> to <6>.
<8> A circuit board comprising a cured product of the magnetic paste according to any one of <1> to <6>.
<9> A circuit board comprising:
   a substrate formed with a through hole; and
   a magnetic layer that is filled in the through hole, wherein
   the magnetic layer comprises a cured product of the magnetic paste according to any one of <1> to <6>.
<10> An inductor component comprising the circuit board according to <8> or <9>.
<11> A production method of a circuit board, the production method comprising:
   a step of filling a hole in a substrate having the hole formed therein with the magnetic paste according to any one of <1> to <6>; and
   a step of curing the magnetic paste that has been filled in the hole.
<12> A production method of the magnetic paste according to any one of <1> to <6>, the production method comprising:
   a step of mixing (A) a magnetic powder and (B) a thermosetting resin to obtain a pasty composition; and
   a step of vacuum drying the pasty composition at an absolute pressure of 800 Pa or less.

### Advantageous Effects of Invention

According to the present invention, it is possible to provide a magnetic paste that has a small viscosity change with passage of time while a magnetic powder having a small particle diameter is included therein, and a production method thereof; a cured product of the magnetic paste; a circuit board containing the cured product of the magnetic paste and a production method thereof; and an inductor component comprising the circuit board.

### Brief Description of Drawings

FIG. 1 is a schematic cross sectional view illustrating the core substrate before being formed with the through hole in the production method of the circuit board according to one embodiment of the present invention.
FIG. 2 is a schematic cross sectional view illustrating the core substrate formed with a through hole in the production method of the circuit board according to one embodiment of the present invention.
FIG. 3 is a schematic cross sectional view illustrating the core substrate formed with a plated layer in the through hole in the production method of the circuit board according to one embodiment of the present invention.
FIG. 4 is a schematic cross sectional view illustrating the state of the through hole in the core substrate filled with the magnetic paste in the production method of the circuit board according to one embodiment of the present invention.
FIG. 5 is a schematic cross sectional view to explain the step (2) in the production method of the circuit board according to one embodiment of the present invention.
FIG. 6 is a schematic cross sectional view to explain the step (3) in the production method of the circuit board according to one embodiment of the present invention.
FIG. 7 is a schematic cross sectional view to explain the step (5) in the production method of the circuit board according to one embodiment of the present invention.
FIG. 8 is a schematic cross sectional view to explain the step (5) in the production method of the circuit board according to one embodiment of the present invention.

### Description of Embodiments

Hereinafter, the present invention will be described in detail by embodiments and examples. The present invention is not limited to the embodiments and examples described below; thus, the present invention may be carried out with any modification so far as such modification is not outside the claims or the equivalent thereof.

In the explanation hereinafter, the resin component in the magnetic paste means the components excluding inorganic particles such as a magnetic powder from nonvolatile components included in the magnetic paste, unless otherwise specifically mentioned.

### <Overview of Magnetic Paste>

The magnetic paste according to one embodiment of the present invention includes (A) a magnetic powder and (B) a thermosetting resin. (A) The magnetic powder has a small average particle diameter that is equal to or smaller than a specific value. The water content in the magnetic paste is in a specific low range.

While the magnetic paste according to the present embodiment includes (B) the magnetic powder having an average particle diameter that is equal to or smaller than a specific value, the magnetic paste can reduce the viscosity change with passage of time. Therefore, when a hole is filled with the magnetic paste, an adjustment frequency of the filling condition can be reduced. Therefore, while (B) the magnetic powder having a small particle diameter is employed, it is possible to obtain the magnetic paste that can be readily filled into the hole. Usually, in this magnetic paste, (B) the magnetic powder having a small particle diameter can be employed, and in addition, the content of (B) the magnetic powder can be increased; thus, it is possible to improve the magnetic properties such as a relative magnetic permeability and a magnetic loss.

A magnetic paste that contains a magnetic powder having a small particle diameter has been conventionally studied. In general, the conventional magnetic paste is applied onto a surface of a substrate to form a layer, and the resulting layer of the magnetic paste is cured to form a magnetic layer. Such a conventional magnetic layer as described above does not require precise viscosity control.

In contrast, the inventor of the present invention prepared a substrate (hereinafter may be referred to as "core substrate") having a hole formed therein, and attempted to fill the hole in the core substrate with a magnetic paste followed by curing it to form the magnetic layer. In order to fill the hole, a precise control of the viscosity is required. For example, in order to ensure smooth entry of the magnetic paste into the hole, the viscosity of the magnetic paste is required to be low. On the other hand, in the case where the hole is a through hole that goes through the core substrate, the viscosity of the magnetic paste is required to be high in order to prevent the magnetic paste from being flowed out through the through hole. Therefore, in order to achieve both promotion of entry and suppression of leakage, precise control of the viscosity of the magnetic paste is required. However, the viscosity of those conventional magnetic pastes changed with passage of time, and thus smooth filling of the hole was difficult. When the above-mentioned implementation of the new technology of filling the hole formed in the core substrate with the magnetic paste is studied, the problem of the viscosity change with passage of time emerged for the first time.

The inventor of the present invention has studied this problem, and as a result, has found that a water amount in the magnetic paste that includes a magnetic powder having small diameter increases with passage of time, and that this water has a significant effect on the change in the viscosity of the magnetic paste. In the magnetic paste according to the present embodiment, suppression of the viscosity change of the magnetic paste with passage of time has been achieved by reducing the water content in the magnetic paste to a specific value or less.

### <(A) Magnetic Powder>

The magnetic paste according to one embodiment of the present invention includes (A) a magnetic powder as the component (A). As for (A) the magnetic powder, a particle of the material having a relative magnetic permeability of more than 1 may be used. In general, the material of (A) the magnetic powder is an inorganic material, and may be any of a soft magnetic material and a hard magnetic material. The material of (A) the magnetic powder may be used singly or in a combination of two or more of them. Therefore, (A) the magnetic powder may be any of a soft magnetic powder, a hard magnetic powder, and a combination of the soft magnetic powder and the hard magnetic powder. (A) The magnetic powder may be used singly or as a combination of two or more of them. In particular, from the viewpoint of clearly obtaining the advantageous effects of the present invention, (A) the magnetic powder preferably includes a soft magnetic powder, and more preferably includes only the soft magnetic powder.

Illustrative examples of (A) the magnetic powder may include a magnetic metal oxide powder and a magnetic metal powder.

Illustrative examples of the magnetic metal oxide powder may include ferrite powders such as a Fe-Mn type ferrite powder, a Fe-Mn-Mg type ferrite powder, a Fe-Mn-Mg-Sr type ferrite powder, a Fe-Mg-Zn type ferrite powder, a Fe-Mg-Sr type ferrite powder, a Fe-Zn-Mn type ferrite powder, a Fe-Cu-Zn type ferrite powder, a Fe-Ni-Zn type ferrite powder, a Fe-Ni-Zn-Cu type ferrite powder, a Fe-Ba-Zn type ferrite powder, a Fe-Ba-Mg type ferrite powder, a Fe-Ba-Ni type ferrite powder, a Fe-Ba-Co type ferrite powder, a Fe-Ba-Ni-Co type ferrite powder, and a Fe-Y type ferrite powder; and iron oxide powders such as an iron (III) oxide powder and a tri-iron tetroxide powder. Among these, ferrite powders are preferable. Usually, the ferrite powder is composed of a composite oxide including an iron oxide as the main component thereof, and is chemically stable. Therefore, the ferrite powder offers advantages such as a high corrosion resistance, a low risk of ignition, and a resistance to demagnetization. Among them, the ferrite powders containing at least one element selected from the group consisting of Mn and Zn are preferable. The ferrite powders containing Mn are more preferable. A Fe-Mn type ferrite powder and a Fe-Mn-Zn type ferrite powder are particularly preferable. The Fe-Mn type ferrite powder represents the ferrite powder containing Fe and Mn. The Fe-Mn-Zn type ferrite powder represents the ferrite powder containing Fe, Mn, and Zn.

Illustrative examples of the magnetic metal powder may include a pure iron powder; and crystalline or non-crystalline alloy powders such as a Fe-Si type alloy powder, a Fe-Si-Al type alloy powder, a Fe-Cr type alloy powder, a Fe-Cr-Si type alloy powder, a Fe-Ni-Cr type alloy powder, a Fe-Cr-Al type alloy powder, a Fe-Ni type alloy powder, a Fe-Ni-Si type alloy powder, a Fe-Ni-B type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder. Among them, the alloy powders are preferable, and the iron alloy type powders are more preferable. As for the iron alloy type powder, the iron alloy type powder containing Fe, as well as at least one element selected from the group consisting of Si, Cr, and Ni is preferable; and the Fe-Cr-Si type alloy powder and the Fe-Ni type alloy powder are especially preferable. The Fe-Cr-Si type alloy powder represents the alloy powder containing Fe, Cr, and Si; and the Fe-Ni type alloy powder represents the alloy powder containing Fe and Ni.

As for (A) the magnetic powder, commercially available magnetic powders may be used. Some commercially available magnetic powders may not have the average particle diameter equal to or smaller than a specific value; but such magnetic powders may be used by processing such as classification or crushing to reduce the average particle diameter thereof. Specific examples of the commercially available magnetic powder may include "M05S", "M001", and "MZ05S", manufactured by Powdertech Co., Ltd.; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", and "Fe-80Ni-4MoPF20F", manufactured by Epson Atmix Corp.; "LD-M", "LD-MH", "KNI-106", "KNI-106GSM", "KNI-106GS", "KNI-109", "KNI-109GSM", and "KNI-109GS", manufactured by JFE Chemical Corp.; "KNS-415", "BSF-547", "BSF-029", "BSN-125", "BSN-125", "BSN-714", "BSN-828", "S-1281", "S-1641", "S-1651", "S-1470", "S-1511", and "S-2430", manufactured by Toda Kogyo Corp.; "JR09P2" manufactured by Japan Metals and Chemicals Co., Ltd.; "Nanotek" manufactured by CIK-NanoTek Corp.; "JEMK-S" and "JEMK-H", manufactured by Kinsei Matec Co., Ltd.; "Yttrium Iron Oxide" manufactured by Aldrich Corp.; and "MA-RCO-5" manufactured by Dowa Electronics Materials Co., Ltd. (A) The magnetic powder may be used singly or in a combination of two or more of them.

(A) The magnetic powder usually has an average particle diameter of 10 um or less. Specifically, the range of the average particle diameter of (A) the magnetic powder is usually 10 um or less, preferably 9 um or less, more preferably 8 um or less, still more preferably 7 um or less, still more preferably 6 um or less, and especially preferably 5 um or less. By using the magnetic paste according to the present embodiment, it is possible to suppress the problem of the viscosity change with passage of time that has emerged when the magnetic paste that contains (A) the magnetic powder having a small particle diameter is used. In addition, when (A) the magnetic paste having a small particle diameter as described above is used, it is usually possible to suppress the magnetic loss of the cured product of the magnetic paste. There is no particular restriction in the lower limit of the average particle diameter of (A) the magnetic powder; so, the lower limit may be , for example, 0.05 um or more, 0.5 um or more, or 1 um or more.

The average particle diameter is the median diameter on a volume basis, unless otherwise specifically mentioned. The average particle diameter can be measured with a laser diffraction scattering method based on the Mie scattering theory. Specifically, the particle diameter distribution thereof is prepared on a volume basis by using a laser diffraction scattering type particle diameter distribution analyzer, in which the median diameter thereof may be measured as the average particle diameter. The powders that are dispersed in water by means of an ultrasonic wave may be suitably used as the measurement sample. Illustrative examples of the laser diffraction scattering type particle diameter distribution analyzer that can be used may include "LA-500" manufactured by Horiba Ltd. and "SALD-2200" manufactured by Shimadzu Corp.

From the viewpoint of obtaining a higher relative magnetic permeability, the specific surface area of (A) the magnetic powder is preferably 0.05 m²/g or more, more preferably 0.1 m²/g or more, and still more preferably 0.3 m²/g or more, and is preferably 10 m²/g or less, more preferably 8 m²/g or less, and still more preferably 5 m²/g or less. The specific surface area of (A) the magnetic powder can be measured by the BET method. Specifically, the specific surface area can be measured according to the BET method by adsorbing a nitrogen gas onto the sample surface using a specific surface area measurement instrument ("Macsorb HM Model 1210" manufactured by Mountech Co., Ltd.) with the BET method.

The particle of (A) the magnetic powder is preferably spherical or ellipsoidal. The ratio (aspect ratio) of the length of the longitude axis with respect to the length of the short axis of the particles of (A) the magnetic powder is preferably 2 or less, more preferably 1.5 or less, and still more preferably 1.2 or less, and is usually 1.0 or more. In general, when the particle shape of the magnetic powder is not a spherical shape but a flat shape, a relative magnetic permeability can be increased readily. On the other hand, when the particle shape of the magnetic powder is close to a spherical shape, the magnetic loss can be decreased readily.

The true specific gravity of (A) the magnetic powder may be, for example, in the range of 4 g/cm³ to 10 g/cm³.

The amount (% by volume) of (A) the magnetic powder included in the magnetic paste is preferably 30% by volume or more, more preferably 40% by volume or more, and especially preferably 50% by volume or more, and is preferably 95% by volume or less, more preferably 85% by volume or less, and especially preferably 75% by volume or less, relative to 100% by volume of the nonvolatile components in the magnetic paste. In the case where the amount (% by volume) of (A) the magnetic powder is within the above-mentioned range, the viscosity change with passage of time conventionally tends to be especially large, but the magnetic paste according to the present embodiment can suppress the viscosity change with passage of time. In addition, in the case where the amount (% by volume) of (A) the magnetic powder is within the above-mentioned range, the viscosity of the magnetic paste can usually be appropriately controlled to improve the filling property, and the magnetic properties such as the relative magnetic permeability and the magnetic loss can usually be effectively improved.

The amount (% by volume) of each component in the magnetic paste can be determined by calculation from the mass of the component in the magnetic paste. Specifically, the mass is divided by the specific gravity to obtain the volume of each component; and the amount (% by volume) based on the volume can be calculated from the volume of each component obtained.

The amount (% by mass) of (A) the magnetic powder included in the magnetic paste is preferably 60% by mass or more, more preferably 70% by mass or more, and especially preferably 80% by mass or more, and is preferably 99% by mass or less, more preferably 95% by mass or less, and especially preferably 92% by mass or less, relative to 100% by mass of the nonvolatile components in the magnetic paste. In the case where the amount (% by mass) of (A) the magnetic powder is within the above-mentioned range, the viscosity change with passage of time conventionally tends to be especially large, but the magnetic paste according to the present embodiment can suppress the viscosity change with passage of time. In addition, in the case where the amount (% by mass) of (A) the magnetic powder is within the above-mentioned range, the viscosity of the magnetic paste can usually be appropriately controlled to improve the filling property, and the magnetic properties such as the relative magnetic permeability and the magnetic loss can usually be effectively improved.

### <(B) Thermosetting Resin>

The magnetic paste according to one embodiment of the present invention includes (B) a thermosetting resin as the component (B). In general, (B) the thermosetting resin can bind (A) the magnetic powder. In addition, in general, (B) the thermosetting resin can undergo a reaction by heat to form a bond thereby curing the magnetic paste. Thus, the magnetic paste including (A) the magnetic powder and (B) the thermosetting resin in combination can be cured to form the magnetic layer.

Illustrative examples of (B) the thermosetting resin may include an epoxy resin, a phenol type resin, an active ester type resin, an amine type resin, an acid anhydride type resin, a benzoxazine type resin, a cyanate ester type resin, and a carbodiimide type resin. (B) The thermosetting resin may be used singly or in a combination of two or more of them.

It is preferable that (B) the thermosetting resin includes (B-1) an epoxy resin. (B-1) The epoxy resin represents the resin having one or more epoxy groups in one molecule thereof. When (B) the thermosetting resin includes (B-1) the epoxy resin, the viscosity change of the magnetic paste with passage of time can be effectively suppressed, and usually the magnetic properties of the cured product can be effectively improved.

Illustrative examples of (B-1) the epoxy resin may include a bixylenol type epoxy resin, a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolac type epoxy resin; a glycidylamine type epoxy resin; a glycidyl ester type epoxy resin; a cresol novolac type epoxy resin; a biphenyl type epoxy resin; a linear aliphatic epoxy resin; an epoxy resin containing a butadiene structure; an alicyclic epoxy resin; an alicyclic epoxy resin containing an ester skeleton; a heterocyclic epoxy resin; an epoxy resin containing a spiro ring; a cyclohexane type epoxy resin; a cyclohexane dimethanol type epoxy resin; a trimethylol type epoxy resin; a tetraphenylethane type epoxy resin; epoxy resins containing a condensed ring skeleton such as a naphthylene ether type epoxy resin, a tert-butyl-catechol type epoxy resin, a naphthalene type epoxy resin, a naphthol type epoxy resin, an anthracene type epoxy resin, and a naphthol novolac type epoxy resin; an isocyanurate type epoxy resin; an epoxy resin containing an alkyleneoxy skeleton and a butadiene skeleton; and an epoxy resin containing a fluorene structure. (B-1) The epoxy resin may be used singly or in a combination of two or more of them.

It is preferable that (B-1) the epoxy resin includes an epoxy resin having two or more epoxy groups in one molecule thereof. The ratio of the epoxy resin having two or more epoxy groups in one molecule thereof relative to 100% by mass of the total amount of (B-1) the epoxy resin is preferably 50% by mass or more, more preferably 60% by mass or more, and especially preferably 70% by mass or more.

It is preferable that (B-1) the epoxy resin contains an aromatic structure. When two or more epoxy resins are used, it is preferable that one or more of the epoxy resins contain the aromatic structure. The aromatic structure is the chemical structure that is generally defined as aromatic, including a polycyclic aromatic ring and an aromatic heterocycle.

In (B-1) the epoxy resin, there are an epoxy resin that is in the state of liquid at 20°C (hereinafter may be referred to as "liquid epoxy resin") and an epoxy resin that is in the state of solid at 20°C (hereinafter may be referred to as "solid epoxy resin"). (B-1) The epoxy resin may be only the liquid epoxy resin, or only the solid epoxy resin, or a combination of the liquid epoxy resin and the solid epoxy resin. Among them, (B-1) the epoxy resin preferably includes the liquid epoxy resin, and especially preferably includes only the liquid epoxy resin.

As for the liquid epoxy resin, the liquid epoxy resin having two or more epoxy groups in one molecule thereof is preferable. The liquid epoxy resin is preferably a bisphenol A type epoxy resin, a bisphenol F type epoxy resin, a bisphenol AF type epoxy resin, a naphthalene type epoxy resin, a glycidyl ester type epoxy resin, a glycidylamine type epoxy resin, a phenol novolac type epoxy resin, an alicyclic epoxy resin containing an ester skeleton, a cyclohexane type epoxy resin, a cyclohexane dimethanol type epoxy resin, an epoxy resin containing a butadiene structure, an epoxy resin containing an alkyleneoxy skeleton and a butadiene skeleton, an epoxy resin containing a fluorene structure, and a dicyclopentadiene type epoxy resin. Among them, a bisphenol A type epoxy resin, a bisphenol F type epoxy resin, and a cyclohexane type epoxy resin are especially preferable.

Specific examples of the liquid epoxy resin may include "YX7400" manufactured by Mitsubishi Chemical Corp.; "HP4032", "HP4032D", and "HP4032SS", manufactured by DIC Corp. (naphthalene type epoxy resin); "828US", "828EL", "jER828EL", "825", and "Epikote 828EL", manufactured by Mitsubishi Chemical Corp. (bisphenol A type epoxy resin); "jER807" and "1750", manufactured by Mitsubishi Chemical Corp. (bisphenol F type epoxy resin); "jER152" manufactured by Mitsubishi Chemical Corp. (phenol novolac type epoxy resin); "630", "630LSD", and "604", manufactured by Mitsubishi Chemical Corp. (glycidylamine type epoxy resin); "ED-523T" manufactured by ADEKA Corp. (glycyrol type epoxy resin); "EP-3950L" and "EP-3980S", manufactured by ADEKA Corp. (glycidylamine type epoxy resin); "EP-4088S" manufactured by ADEKA Corp. (dicyclopentadiene type epoxy resin); "ZX-1059" manufactured by Nippon Steel Chemical & Material Co., Ltd. (mixture of bisphenol A type epoxy resin and bisphenol F type epoxy resin); "EX-721" manufactured by Nagase ChemteX Corp. (glycidyl ester type epoxy resin); "EX-991L" manufactured by Nagase ChemteX Corp. (epoxy resin containing an alkyleneoxy skeleton); "Celloxide 2021P" and "Celloxide 2081", manufactured by Daicel Corp. (alicyclic epoxy resin containing ester skeleton); "PB-3600" manufactured by Daicel Corp., "JP-100" and "JP-200", manufactured by Nippon Soda Co., Ltd. (epoxy resin containing butadiene skeleton); "ZX-1658" and "ZX-1658GS", manufactured by Nippon Steel Chemical & Material Co., Ltd. (liquid 1,4-glycidylcyclohexane type epoxy resin); and "EG-280" manufactured by Osaka Gas Chemicals Co., Ltd. (epoxy resin containing fluorene structure). These liquid epoxy resins may be used singly or in a combination of two or more of them.

As for the solid epoxy resin, the solid epoxy resin having three or more epoxy groups in one molecule thereof is preferable; the aromatic solid epoxy resin having three or more epoxy groups in one molecule thereof is more preferable. The solid epoxy resin is preferably a bixylenol type epoxy resin, a naphthalene type epoxy resin, a naphthalene type four-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, or a tetraphenylethane type epoxy resin. The dicyclopentadiene type epoxy resin is especially preferable.

Specific examples of the solid epoxy resin may include "HP4032H" manufactured by DIC Corp. (naphthalene type epoxy resin); "HP-4700" and "HP-4710" manufactured by DIC Corp. (naphthalene type four-functional epoxy resin); "N-690" manufactured by DIC Corp. (cresol novolac type epoxy resin); "N-695" manufactured by DIC Corp. (cresol novolac type epoxy resin); "HP-7200", "HP-7200HH", and "HP-7200H" manufactured by DIC Corp. (dicyclopentadiene type epoxy resin); "EXA-7311", "EXA-7311-G3", "EXA-7311-G4", "EXA-7311-G4S", and "HP6000", manufactured by DIC Corp. (naphthylene ether type epoxy resin); "EPPN-502H" manufactured by Nippon Kayaku Co., Ltd. (trisphenol type epoxy resin); "NC7000L" manufactured by Nippon Kayaku Co., Ltd. (naphthol novolac type epoxy resin); "NC3000H", "NC3000", "NC3000L", and "NC3100", manufactured by Nippon Kayaku Co., Ltd. (biphenyl type epoxy resin); "ESN475V" manufactured by Nippon Steel Chemical & Material Co., Ltd. (naphthol type epoxy resin); "ESN485" manufactured by Nippon Steel Chemical & Material Co., Ltd. (naphthol novolac type epoxy resin); "YX4000H", "YX4000", and "YL6121", manufactured by Mitsubishi Chemical Corp. (biphenyl type epoxy resin); "YX4000HK" manufactured by Mitsubishi Chemical Corp. (bixylenol type epoxy resin); "YX8800" manufactured by Mitsubishi Chemical Corp. (anthracene type epoxy resin); "YX7700" manufactured by Mitsubishi Chemical Corp. (novolac type epoxy resin containing a xylene structure); "PG-100" and "CG-500", manufactured by Osaka Gas Chemicals Co., Ltd.; "YL7760" manufactured by Mitsubishi Chemical Corp. (bisphenol AF type epoxy resin); "YL7800" manufactured by Mitsubishi Chemical Corp. (fluorene type epoxy resin); "jER1010" manufactured by Mitsubishi Chemical Corp. (solid bisphenol A type epoxy resin); and "jER1031S" manufactured by Mitsubishi Chemical Corp. (tetraphenylethane type epoxy resin). These solid epoxy resins may be used singly or in a combination of two or more of them.

In the case where a combination of the liquid epoxy resin and the solid epoxy resin is used as the epoxy resin, the mass ratio (liquid epoxy resin/solid epoxy resin) of the liquid epoxy resin with respect to the solid epoxy resin is preferably 0.5 or more, more preferably 1 or more, still more preferably 5 or more, and especially preferably 10 or more.

The epoxy equivalent of (B-1) the epoxy resin is preferably in the range of 50 g/eq. to 5000 g/eq., more preferably in the range of 50 g/eq. to 3000 g/eq., still more preferably in the range of 80 g/eq. to 2000 g/eq., and far still more preferably in the range of 110 g/eq. to 1000 g/eq. The epoxy equivalent is the mass of the resin per one equivalent of the epoxy group. The epoxy equivalent can be measured in accordance with JIS K7236.

The weight-average molecular weight (Mw) of (B-1) the epoxy resin is preferably in the range of 100 to 5000, more preferably in the range of 250 to 3000, and still more preferably in the range of 400 to 1500. The weight-average molecular weight of the resin can be measured in terms of polystyrene by a gel permeation chromatography (GPC) method.

The amount (% by mass) of (B-1) the epoxy resin included in the magnetic paste is preferably 0.1% by mass or more, more preferably 0.5% by mass or more, and especially preferably 1% by mass or more, and is preferably 30% by mass or less, more preferably 20% by mass or less, and especially preferably 15% by mass or less, relative to 100% by mass of the nonvolatile components in the magnetic paste. When the amount of (B-1) the epoxy resin is within the above-mentioned range, the viscosity change of the magnetic paste with passage of time can be effectively suppressed, and usually the magnetic properties of the cured product can be effectively improved.

The amount (% by mass) of (B-1) the epoxy resin included in the magnetic paste is preferably 10% by mass or more, more preferably 20% by mass or more, and especially preferably 30% by mass or more, and is preferably 99% by mass or less, more preferably 98% by mass or less, and especially preferably 97% by mass or less, relative to 100% by mass of the resin components in the magnetic paste. When the amount of (B-1) the epoxy resin is within the above-mentioned range, the viscosity change of the magnetic paste with passage of time can be effectively suppressed, and usually the magnetic properties of the cured product can be effectively improved.

In the case where (B) the thermosetting resin includes (B-1) the epoxy resin, (B) the thermosetting resin may include a resin that is capable of undergoing the reaction with (B-1) the epoxy resin to form a bond. Hereinafter, the resin that is capable of undergoing the reaction with (B-1) the epoxy resin to form a bond may be referred to as "(B-2) a curing agent". Illustrative examples of (B-2) the curing agent may include a phenol type resin, an active ester type resin, an amine type resin, a carbodiimide type resin, an acid anhydride type resin, a benzoxazine type resin, a cyanate ester type resin, and a thiol type resin. (B-2) The curing agent may be used singly or in a combination of two or more of them.

As for the phenol type resin, a resin having one or more, preferably two or more, hydroxyl groups bonding to an aromatic ring such as a benzene ring or a naphthalene ring in one molecule thereof may be used. In view of the heat resistance and the water resistance, a phenol type resin containing a novolac structure is preferable. In view of the adhesion property, a nitrogen-containing phenol type resin is preferable, and a phenol type resin containing a triazine skeleton is more preferable. In particular, from the viewpoint of highly satisfying a heat resistance, a water resistance, and an adhesion property, a phenol novolac resin containing a triazine skeleton is preferable.

Specific examples of the phenol type resin may include "MEH-7700", "MEH-7810", "MEH-7851", and "MEH-8000H", manufactured by Meiwa Plastic Industries, Ltd.; "NHN", "CBN", and "GPH", manufactured by Nippon Kayaku Co., Ltd.; "SN-170", "SN-180", "SN-190", "SN-475", "SN-485", "SN-495", "SN-495V", "SN-375", and "SN-395", manufactured by Nippon Steel Chemical & Material Co., Ltd.; "TD-2090", "TD-2090-60M", "LA-7052", "LA-7054", "LA-1356", "LA-3018", "LA-3018-50P", "EXB-9500", "HPC-9500", "KA-1160", "KA-1163", and "KA-1165", manufactured by DIC Corp.; and "GDP-6115L", "GDP-6115H", and "ELPC75", manufactured by Gunei Chemical Industry Co., Ltd.

As for the active ester type resin, a compound having one or more, and preferably two or more active ester groups in one molecule thereof may be used. Among the active ester type resins, the compound having two or more highly reactive ester groups in one molecule thereof are preferable as the active ester type resin, such as a phenol ester type compound, a thiophenol ester type compound, an N-hydroxylamine ester type compound, and an ester compound of a heterocyclic hydroxy compound. The active ester type resin is preferably the compound that is obtained by condensation reaction of a carboxylic acid compound and/or a thiocarboxylic acid compound with a hydroxy compound and/or a thiol compound. Especially, from the viewpoint of improvement of a heat resistance, an active ester type resin obtained from a carboxylic acid compound and a hydroxy compound is preferable, while an active ester type resin obtained from a carboxylic acid compound and a phenol compound and/or a naphthol compound is more preferable. Illustrative examples of the carboxylic acid compound may include benzoic acid, acetic acid, succinic acid, maleic acid, itaconic acid, phthalic acid, isophthalic acid, terephthalic acid, and pyromellitic acid. Illustrative examples of the phenol compound or the naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolac. Here, the "dicyclopentadiene type diphenol compound" means a diphenol compound obtained by condensation of one dicyclopentadiene molecule with two phenol molecules.

Specific examples of the preferable active ester type resin may include an active ester type resin containing a dicyclopentadiene type diphenol structure, an active ester type resin containing a naphthalene structure, an active ester type resin containing an acetylated phenol novolac, and an active ester type resin containing a benzoylated phenol novolac. Among them, the active ester type resin containing a naphthalene structure and the active ester type resin containing a dicyclopentadiene type diphenol structure are more preferable. Here, the "dicyclopentadiene type diphenol structure" means the divalent structure unit formed of phenylene-dicyclopentylene-phenylene.

Illustrative examples of the commercially available product of the active ester type resin may include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (manufactured by DIC Corp.); active ester type resins containing a naphthalene structure, such as "EXB-9416-70BK", "EXB-8150-65T", "EXB-8100L-65T", and "EXB-8150L-65T" (manufactured by DIC Corp.); active ester type resins containing an acetylated phenol novolac, such as "DC808" (manufactured by Mitsubishi Chemical Corp.); active ester type resins containing a benzoylated phenol novolac, such as "YLH1026" (manufactured by Mitsubishi Chemical Corp.); active ester type resins as the acetylated phenol novolac, such as "DC808" (manufactured by Mitsubishi Chemical Corp.); and active ester type resins as the benzoylated phenol novolac, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

As for the amine type resin, a resin having one or more, and preferably two or more amino groups in one molecule thereof may be used. Illustrative examples of the amine type resin may include an aliphatic amine compound, a polyether amine compound, an alicyclic amine compound, and an aromatic amine compound. Among them, an aromatic amine compound is preferable. The amine type resin is preferably a primary amine and a secondary amine; a primary amine is more preferable. Specific examples of the amine type resin may include 4,4'-methylenebis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylenediamine, m-xylylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof may include "KAYABOND C-200S", "KAYABOND C-100", "KAYAHARD A-A", "KAYAHARD A-B", and "KAYAHARD A-S", manufactured by Nippon Kayaku Co. Ltd., as well as "Epicure W" manufactured by Mitsubishi Chemical Corp.

As for the carbodiimide type resin, a resin having one or more, and preferably two or more carbodiimide structures in one molecule thereof may be used. Specific examples of the carbodiimide type resin may include biscarbodiimides including aliphatic biscarbodiimides such as tetramethylene-bis(t-butylcarbodiimide) and cyclohexane-bis(methylene-t-butylcarbodiimide), and aromatic biscarbodiimides such as phenylene-bis(xylylcarbodiimide); and polycarbodiimides including aliphatic polycarbodiimides such as polyhexamethylene carbodiimide, polytrimethylhexamethylene carbodiimide, polycyclohexylene carbodiimide, poly(methylenebiscyclohexylene carbodiimide), and poly(isophorone carbodiimide), and aromatic polycarbodiimides such as poly(phenylene carbodiimide), poly(naphthylene carbodiimide), poly(tolylene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylylene carbodiimide), poly(tetramethylxylylene carbodiimide), poly(methylenediphenylene carbodiimide), and poly[methylenebis(methylphenylene) carbodiimide]. Illustrative examples of the commercially available product of the carbodiimide type resin may include "Carbodilite V-02B", "Carbodilite V-03", "Carbodilite V-04K", "Carbodilite V-07", and "Carbodilite V-09", manufactured by Nisshinbo Chemical Inc.; and "Stabaxol P", "Stabaxol P400", and "Hycasyl 510", manufactured by Rhein Chemie GmbH.

As for the acid anhydride type resin, a resin having one or more acid anhydride groups in one molecule thereof may be used. The resin having two or more acid anhydride groups in one molecule thereof is preferable. Specific examples of the acid anhydride type resin may include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid. Illustrative examples of the commercially available product of the acid anhydride type resin may include "HNA-100", "MH-700", "MTA-15", "DDSA", and "OSA", manufactured by New Japan Chemical Co., Ltd.; "YH-306" and "YH-307", manufactured by Mitsubishi Chemical Corp.; "HN-2200" and "HN-5500", manufactured by Hitachi Chemical Co., Ltd.; and "EF-30", "EF-40, "EF-60", and "EF-80", manufactured by Cray Valley S.A.

Specific examples of the benzoxazine type resin may include "JBZ-OD100", "JBZ-OP100D", and "ODA-BOZ", manufactured by JFE Chemical Corp.; "P-d" and "F-a", manufactured by Shikoku Chemicals Corp.; and "HFB2006M" manufactured by Showa Highpolymer Co., Ltd.

Illustrative examples of the cyanate ester type resin may include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene)(benzene, bis(4-cyanatephenyl) thioether, and bis(4-cyanatephenyl) ether; polyfunctional cyanate resins derived from a phenol novolac, a cresol novolac, and the like; and a prepolymer in which these cyanate resins partially form triazine. Specific examples of the cyanate ester type resin may include "PT30" and "PT60", (phenol novolac type polyfunctional cyanate ester resin); "ULL-950S" (polyfunctional cyanate ester); "BA230" and "BA230S75" (prepolymers in which part or all of bisphenol A dicyanate form triazine so as to be a trimer), manufactured all by Lonza Japan Ltd.

Illustrative examples of the thiol type resin may include trimethylolpropane tris(3-mercaptopropionate), pentaerythritol tetrakis(3-mercaptobutyrate), and tris(3-mercaptopropyl) isocyanurate.

The active group equivalent of (B-2) the curing agent is preferably in the range of 50 g/eq. to 3000 g/eq., more preferably in the range of 100 g/eq. to 1000 g/eq., still more preferably in the range of 100 g/eq. to 500 g/eq., and especially preferably in the range of 100 g/eq. to 300 g/eq. The active group equivalent is the mass of (B-2) the curing agent per one equivalent of the active group.

The number of the active groups in (B-2) the curing agent relative to one epoxy group in (B-1) the epoxy resin is preferably 0.01 or more, more preferably 0.1 or more, and especially preferably 0.5 or more, and is preferably 10 or less, more preferably 5 or less, and especially preferably 3 or less. The active group in (B-2) the curing agent is, for example, an active hydroxy group and the like; they are different depending on kinds of the curing agent. The number of the epoxy groups in (B-1) the epoxy resin is the total value obtained by dividing the mass of the solid components in each epoxy resin with the epoxy equivalent and adding the divided values for all the epoxy resins. The number of the active groups in (B-2) the curing agent is the total value obtained by dividing the mass of the solid components in each curing agent with the active group equivalent and adding the divided values for all the curing agents.

The amount (% by mass) of (B-2) the curing agent included in the magnetic paste is preferably 0.1% by mass or more, more preferably 0.25% by mass or more, and especially preferably 0.5% by mass or more, and is preferably 20% by mass or less, more preferably 10% by mass or less, and especially preferably 5% by mass or less, relative to 100% by mass of the nonvolatile components in the magnetic paste. When the amount of (B-2) the curing agent is within the above-mentioned range, the viscosity change of the magnetic paste with passage of time can be effectively suppressed, and usually the magnetic properties of the cured product can be effectively improved.

The amount (% by mass) of (B-2) the curing agent included in the magnetic paste is preferably 1% by mass or more, more preferably 2.5% by mass or more, and especially preferably 5% by mass or more, and is preferably 50% by mass or less, more preferably 30% by mass or less, and especially preferably 20% by mass or less, relative to 100% by mass of the resin components in the magnetic paste. When the amount of (B-2) the curing agent is within the above-mentioned range, the viscosity change of the magnetic paste with passage of time can be effectively suppressed, and usually the magnetic properties of the cured product can be effectively improved.

When (B) the thermosetting resin is classified by viscosity, it is preferable that (B) the thermosetting resin includes a reactive diluent. The reactive diluent represents a component having a low viscosity included in (B) the thermosetting resin. The specific viscosity of the reactive diluent is usually less than 0.5 Pa·s. There is no particular restriction in the lower limit of the viscosity of the reactive diluent; the lower limit may be, for example, 0.001 Pa·s or more, 0.005 Pa·s or more, or 0.01 Pa·s or more. The viscosity of the reactive diluent may be measured using a Type E viscometer at 25±2°C. When (B) the thermosetting resin includes the reactive diluent, the viscosity of the magnetic paste can be lowered.

The reactive diluent may contain a reactive group such as an epoxy group and an active group as described earlier. Illustrative examples of preferable reactive group contained in the reactive diluent may include an epoxy group, an acrylic group, a methacrylic group, and an oxetane group. Among these, an epoxy group is especially preferable. Therefore, it is preferable to use (B-1) the epoxy resin having a low viscosity as the reactive diluent.

Illustrative examples of the reactive diluent that is commercially available may include "EX-201" (cyclic aliphatic glycidyl ether), "EX-830" and "EX-821" (ethylene glycol type epoxy resin), "EX-212" (hexanediol type epoxy resin), and "ZX1658" and "ZX1658GS" (liquid 1,4-glycidylcyclohexane), manufactured by Nippon Steel Chemical & Material Co., Ltd.; "EP-3980S" (glycidylamine type epoxy resin), "EP-4088S" and "EP-4088L" (dicyclopentadiene type epoxy resin), and "ED-509S" (tert-butylphenyl glycidyl ether), manufactured by ADEKA Corp.; and "X-22-163" (siloxane type epoxy resin) manufactured by Shin-Etsu Chemical Co., Ltd. The reactive diluent may be used singly or in a combination of two or more of them.

The amount (% by mass) of the reactive diluent included in the magnetic paste is preferably 0.1% by mass or more, more preferably 0.5% by mass or more, and especially preferably 1% by mass or more, and is preferably 20% by mass or less, more preferably 10% by mass or less, and especially preferably 7% by mass or less, relative to 100% by mass of the nonvolatile components in the magnetic paste. When the amount of the reactive diluent is within the above-mentioned range, the viscosity change of the magnetic paste with passage of time can be effectively suppressed. In addition, usually, the viscosity of the magnetic paste can be decreased, and the magnetic properties of the cured product can be effectively improved.

The amount (% by mass) of the reactive diluent included in the magnetic paste is preferably 1% by mass or more, more preferably 5% by mass or more, and especially preferably 10% by mass or more, and is preferably 90% by mass or less, more preferably 80% by mass or less, and especially preferably 50% by mass or less, relative to 100% by mass of the resin components in the magnetic paste. When the amount of the reactive diluent is within the above-mentioned range, the viscosity change of the magnetic paste with passage of time can be effectively suppressed. In addition, usually, the viscosity of the magnetic paste can be decreased, and the magnetic properties of the cured product can be effectively improved.

The amount (% by mass) of the reactive diluent included in the magnetic paste is preferably 1% by mass or more, more preferably 5% by mass or more, and especially preferably 10% by mass or more, and is preferably 100% by mass or less, more preferably 75% by mass or less, and especially preferably 50% by mass or less, relative to 100% by mass of (B) the thermosetting resin. When the amount of the reactive diluent is within the above-mentioned range, the viscosity change of the magnetic paste with passage of time can be effectively suppressed. In addition, usually, the viscosity of the magnetic paste can be decreased, and the magnetic properties of the cured product can be effectively improved.

The weight-average molecular weight (Mw) of (B) the thermosetting resin may be in the same range as that of the weight-average molecular weight of (B-1) the epoxy resin.

The amount (% by mass) of (B) the thermosetting resin included in the magnetic paste is preferably 0.1% by mass or more, more preferably 0.5% by mass or more, and especially preferably 1% by mass or more, and is preferably 30% by mass or less, more preferably 20% by mass or less, and especially preferably 15% by mass or less, relative to 100% by mass of the nonvolatile components in the magnetic paste. When the amount of (B) the thermosetting resin is within the above-mentioned range, the viscosity change of the magnetic paste with passage of time can be effectively suppressed, and usually the magnetic properties of the cured product can be effectively improved.

The amount (% by mass) of (B) the thermosetting resin included in the magnetic paste is preferably 10% by mass or more, more preferably 20% by mass or more, and especially preferably 30% by mass or more, and is preferably 99% by mass or less, more preferably 98% by mass or less, and especially preferably 97% by mass or less, relative to 100% by mass of the resin components in the magnetic paste. When the amount of (B) the thermosetting resin is within the above-mentioned range, the viscosity change of the magnetic paste with passage of time can be effectively suppressed, and usually the magnetic properties of the cured product can be effectively improved.

### <(C) Curing Accelerator>

The magnetic paste according to one embodiment of the present invention may further include (C) a curing accelerator as an optional component in combination with the components (A) to (B) described above. (C) The curing accelerator as the component (C) does not include those that fall under the components (A) to (B) described above. (C) The curing accelerator functions as a catalyst to accelerate the curing of (B-1) the epoxy resin; thus, (C) The curing accelerator enables to accelerate the curing of the magnetic paste. Generally, a conventional magnetic paste containing a curing accelerator tends to increase the viscosity thereof as the progress of the reaction of (B) the thermosetting resin with passage of time. On the other hand, in the magnetic paste according to the present embodiment, the viscosity change with passage of time can be usually suppressed even when (C) the curing accelerator is included therein.

Illustrative examples of (C) the curing accelerator may include a phosphorous type curing accelerator, an amine type curing accelerator, an imidazole type curing accelerator, a guanidine type curing accelerator, and a metal type curing accelerator. Among these, an imidazole type curing accelerator is preferable. (C) The curing accelerator may be used singly or in a combination of two or more of them.

Illustrative examples of the imidazole type curing accelerator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin. Among these, 2-ethyl-4-methylimidazole and 1-benzyl-2-phenylimidazole are preferable. Commercially available products may be used as the imidazole type curing accelerator. Illustrative examples thereof may include "P200-H50" manufactured by Mitsubishi Chemical Corp.; and "Curezol 2MZ", "2E4MZ", "Cl1Z", "Cl1Z-CN", "Cl1Z-CNS", "Cl1Z-A", "2MZ-OK", "2MA-OK", "2MA-OK-PW, "2MZA-PW", "2PHZ", and "2PHZ-PW", manufactured by Shikoku Chemicals Corp.

Illustrative examples of the amine type curing accelerator may include: trialkylamines such as triethylamine and tributylamine; and 4-dimethylaminopyridine, benzyl dimethyl amine, 2,4,6-tris(dimethylaminomethyl)phenol, 1,8-diazabicyclo(5,4,0)-undecene, 1,8-diazabicyclo[5,4,0]undecene-7,4-dimethylaminopyridine, and 2,4,6-tris(dimethylaminomethyl)phenol. Among these, 4-dimethylaminopyridine is preferable.

Illustrative examples of the phosphorous type curing accelerator may include triphenyl phosphine, a phosphonium borate compound, tetraphenyl phosphonium tetraphenyl borate, n-butyl phosphonium tetraphenyl borate, tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and tetrabutyl phosphonium decanoate salt are preferable.

Illustrative examples of the guanidine type curing accelerator may include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the metal type curing accelerator may include organometallic complexes or organometallic salts of metals such as cobalt, copper, zinc, iron, nickel, manganese, and tin. Specific examples of the organometallic complex may include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt may include zinc octylate, tin octylate, zinc naphthenate, cobalt naphthenate, tin stearate, and zinc stearate.

The amount (% by mass) of (C) the curing accelerator included in the magnetic paste may be 0% by mass, or more than 0% by mass, and is preferably 0.001% by mass or more, more preferably 0.01% by mass or more, especially preferably 0.1% by mass or more, preferably 5% by mass or less, more preferably 3% by mass or less, and especially preferably 1% by mass or less, relative to 100% by mass of the nonvolatile components in the magnetic paste.

The amount (% by mass) of (C) the curing accelerator included in the magnetic paste may be 0% by mass, or more than 0% by mass, and is preferably 0.01% by mass or more, more preferably 0.1% by mass or more, especially preferably 1% by mass or more, preferably 20% by mass or less, more preferably 15% by mass or less, and especially preferably 10% by mass or less, relative to 100% by mass of the resin components in the magnetic paste.

### <(D) Dispersant>

The magnetic paste according to one embodiment of the present invention may further include (D) a dispersant as an optional component in combination with the components (A) to (C) described above. (D) The dispersant as the component (D) does not include those that fall under the components (A) to (C) described above. According to (D) the dispersant, the dispersibility of (A) the magnetic powder can be effectively enhanced; thus, the viscosity of the magnetic paste can be effectively decreased.

There is no restriction in the type of (D) the dispersant. Example of (D) the dispersant that can be used may include a dispersant that contains a functional group having an adsorption ability to (A) the magnetic powder and that disperses (A) the magnetic powder by repulsion (for example, electrostatic repulsion and steric repulsion,) among (D) the dispersants when the dispersant adsorbs onto (A) the magnetic powder. Illustrative examples of (D) the dispersant may include an acidic dispersant and a basic dispersant.

The acidic dispersant usually contains an acidic functional group such as a carboxyl group, a sulfo group (-SO₃H), a sulfate group (-OSO₃H), a phosphono group (-PO(OH)₂), a phosphonooxy group (-OPO(OH)₂), a hydroxyphosphoryl group (-PO(OH)-), and a sulfanyl group (-SH). The acidic functional group usually has a dissociative proton and may be neutralized by a base such as an amine and a hydroxide ion. Preferable examples of the acidic dispersant may include an acidic polymer dispersant containing a polymer chain such as a polyoxyalkylene chain or a polyether chain. Preferable examples of the acidic dispersant may include "C-2093I" and "SC-1015F" (multifunctional comb-type functional polymer having an ionic group in the main chain and a polyoxyalkylene chain in the graft chain), manufactured by NOF Corp.; "DA-375" (polyether phosphate ester compound type dispersant) manufactured by Kusumoto Chemicals, Ltd.; "RS-410", "RS-610", and "RS-710" (pH: 1.9) (phosphate ester type dispersant) of the "Phosphanol" series, manufactured by TOHO Chemical Industry Co., Ltd.; and "AKM-0531", "AFB-1521", "SC-0505K", and "SC-0708A" of the "Marialim" series manufactured by NOF Corp.

The basic dispersant usually contains a basic functional group such as a primary, a secondary, or a tertiary amino group; an ammonium group; an imino group; and a nitrogen-containing heterocyclic group such as pyridine, pyrimidine, pyrazine, imidazole, or triazole. The basic functional group may be neutralized by an acid such as an organic acid or an inorganic acid. Preferable examples of the basic dispersant may include a basic polymer dispersant containing a polymer chain such as a polyester chain. Preferable examples of the basic dispersant may include "Ajisper PB881" (polyamine type dispersant containing a polyester chain) manufactured by Ajinomoto Fine-Techno Co., Inc.

(D) The dispersant may be used singly or in a combination of two or more of them.

The amount (% by mass) of (D) the dispersant included in the magnetic paste may be 0% by mass, or more than 0% by mass, and is preferably 0.01% by mass or more, more preferably 0.1% by mass or more, especially preferably 0.2% by mass or more, preferably 5% by mass or less, more preferably 3% by mass or less, and especially preferably 2% by mass or less, relative to 100% by mass of the nonvolatile components in the magnetic paste. When the amount of (D) the dispersant is within the above-mentioned range, the viscosity of the magnetic paste can be made lower. In addition, usually, the viscosity change of the magnetic paste with passage of time can be effectively suppressed, and the magnetic properties of the cured product can be effectively improved.

The amount (% by mass) of (D) the dispersant included in the magnetic paste may be 0% by mass, or more than 0% by mass, and is preferably 0.1% by mass or more, more preferably 1% by mass or more, especially preferably 2% by mass or more, preferably 20% by mass or less, more preferably 10% by mass or less, and especially preferably 6% by mass or less, relative to 100% by mass of the resin components in the magnetic paste. When the amount of (D) the dispersant is within the above-mentioned range, the viscosity of the magnetic paste can be made lower. In addition, usually, the viscosity change of the magnetic paste with passage of time can be effectively suppressed, and the magnetic properties of the cured product can be effectively improved.

### <(E) Optional Additive>

The magnetic paste according to one embodiment of the present invention may further include (E) an optional additive as the optional component in combination with the components (A) to (D) described above. (E) The optional additive as the component (E) does not include those that fall under the components (A) to (D) described above.

Illustrative examples of (E) the optional component may include: thermoplastic resins such as a phenoxy resin, a polyimide resin, a polyvinyl acetal resin, a polyolefin resin, a polybutadiene resin, a polyamide imide resin, a polyether imide resin, a polysulfone resin, a polyether sulfone resin, a polyphenylene ether resin, a polycarbonate resin, a polyether ether ketone resin, and a polyester resin; radical-polymerizable compounds such as a maleimide type radical-polymerizable compound, a vinylphenyl type radical-polymerizable compound, a (meth)acrylic type radical-polymerizable compound, an allyl type radical-polymerizable compound, and a polybutadiene type radical-polymerizable compound; radical polymerization initiators such as a peroxide type radical polymerization initiator and an azo type radical polymerization initiator; inorganic particles (inorganic fillers) such as a silica particle; organic fillers such as a rubber particle; organic metal compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; ultraviolet absorbers such as a benzotriazole type ultraviolet absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); and stabilizers such as a borate type stabilizer, a titanate type stabilizer, an aluminate type stabilizer, a zirconate type stabilizer, an isocyanate type stabilizer, a carboxylic type stabilizer, and a carboxylic anhydride type stabilizer. (E) The optional additive may be used singly or in a combination of two or more of them.

### <Water Content in Magnetic Paste>

The magnetic paste according to one embodiment of the present invention may contain water as a volatile component in combination with the nonvolatile components such as the components (A) to (E) described above. However, the water content in the magnetic paste according to the present embodiment is within a specific low range. Therefore, the magnetic paste according to the present embodiment may or may not contain water, but the amount of water is usually small, and preferably the magnetic paste does not include water.

Specifically, the range of the water content in the magnetic paste is usually 1000 ppm or less, preferably 950 ppm or less, and more preferably 900 ppm or less. When the water content in the magnetic paste is small, the viscosity change of the magnetic paste with passage of time can be made lower even when the magnetic powder having a small particle diameter is included therein. The lower limit of the water content is ideally 0 ppm, but may be 100 ppm or more, 200 ppm or more, or 300 ppm or more from the viewpoint of easy production of the magnetic paste. The water content in the magnetic paste may be measured by a Karl Fischer method at 25°C. Specific measurement conditions may be adopted from the method described in Examples.

Here, the water content [ppm] in the magnetic paste is represented by Cw, the average particle diameter [um] of (A) the magnetic powder is represented by D_{A}, and the mass ratio [% by mass] of (A) the magnetic powder with respect to 100% by mass of the nonvolatile components in the magnetic paste is represented by C_{M}.

Then, the ratio "C_{W}/C_{M}" is preferably 11.5 or less, more preferably 11.0 or less, and especially preferably 10.5 or less. There is no particular restriction in the lower limit thereof; the lower limit may be 0.0 or more, 0.1 or more, or 0.2 or more. The ratio "C_{W}/C_{M}" corresponds to the water content per mass of (A) the magnetic powder. When the ratio "C_{W}/C_{M}" is within the above-mentioned range, the viscosity change of the magnetic paste with passage of time can be effectively made lower.

The parameter "Cw/ (D_{A}²×C_{M})" is preferably 1.25 or less, more preferably 1.20 or less, and especially preferably 1.15 or less. There is no particular restriction in the lower limit thereof; the lower limit may be 0.00 or more, 0.01 or more, or 0.02 or more. The parameter "Cw/ (D_{A}²×C_{M})" are correlated with the amount of water per surface area of (A) the magnetic powder when (A) the magnetic powder is assumed to be spherical. When the parameter "Cw/ (D_{A}²×C_{M})" is within the above-mentioned range, the viscosity change of the magnetic paste with passage of time can be effectively made lower.

### <(F) Organic Solvent>

The magnetic paste according to one embodiment of the present invention may further include (F) an organic solvent as the volatile component in combination with the nonvolatile components such as the components (A) to (E) described above.

Illustrative examples of (F) the organic solvent may include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. (F) The organic solvent may be used singly or in a combination of two or more of them.

The amount of the organic solvent contained in the magnetic paste is preferably less than 1.0% by mass, more preferably 0.8% by mass or less, more preferably 0.5% by mass or less, and especially preferably 0.1% by mass or less, relative to the total mass of the magnetic paste. The lower limit thereof may be, for example, 0.001% by mass or more, but this is preferably 0% by mass. In other words, it is preferable that the magnetic paste does not contain the organic solvent. Especially, the amount of the organic solvent that has a boiling point of usually 150°C or lower, preferably 140°C or lower, and more preferably 130°C or lower is preferably within the above-mentioned range. When the amount of the organic solvent in the magnetic paste is small, the viscosity change due to volatilization of the organic solvent can be suppressed, so that the viscosity change of the magnetic paste with passage of time can be effectively made lower. Furthermore, usually the generation of a void caused by volatilization of the organic solvent during thermal curing of the magnetic paste can be suppressed.

### <Production Method of Magnetic Paste>

The magnetic paste can be produced, for example, by the method that includes a step (i) of mixing magnetic paste materials to obtain a pasty composition and a step (ii) of drying the pasty composition to obtain a magnetic paste.

In the step (i), (A) the magnetic powder and (B) the thermosetting resin, and as needed, optional components such as (C) the curing accelerator, (D) the dispersant, (E) the optional additive, and (F) the organic solvent are mixed to obtain a pasty composition. The components (A) to (F), which are the materials for the magnetic paste, may be mixed in part or in whole at the same time or in sequence. Mixing may be done at room temperature or at the temperature that is set appropriately during the course of mixing each material. Therefore, during mixing, it may be heated and/or cooled temporarily or throughout the process. In addition, in the course of mixing of each material, stirring or shaking may be carried out.

In the step (ii), the pasty composition is dried to obtain the magnetic paste according to the present embodiment. Due to the penetration of water from an air, the pasty composition prepared at the step (i) may contain water. In the step (ii), this water is removed to obtain the magnetic paste that has a water content within the specific range described before.

Drying of the pasty composition is carried out preferably by vacuum drying. In vacuum drying, the pasty composition is usually accommodated in a vessel under a reduced pressure to remove the water from the pasty composition. When carrying out the vacuum drying, the absolute pressure inside the vessel is usually 800 Pa or less, preferably 750 Pa or less, more preferably 600 Pa or less, and especially preferably 400 Pa or less. The lower limit thereof is ideally 0 Pa, but the lower limit may be 100 Pa or more, or 200 Pa or more. When drying is carried out under such a high vacuum, the water can be removed smoothly from the pasty composition, so that the magnetic paste can be produced in a short time.

It is preferable that the drying of the pasty composition is carried out at room temperature or under a cooled environment. Specifically, the drying temperature of the pasty composition is preferably 30°C or lower, more preferably 25°C or lower, and especially preferably 20°C or lower. There is no particular restriction in the lower limit thereof; so the lower limit may be 5°C or higher, 10°C or higher, or 15°C or higher. When the drying temperature is within the above-mentioned range, it is possible to suppress the progress of the curing reaction of (B) the thermosetting resin, thereby enabling to decrease the viscosity of the magnetic paste to be produced.

The drying time of the pasty composition may be set appropriately within the range to obtain the magnetic paste having a water content in the above-mentioned range. Specifically, the drying time is preferably 10 minutes or longer, more preferably 20 minutes or longer, and still more preferably 30 minutes or longer, and is preferably 24 hours or shorter, more preferably 12 hours or shorter, and still more preferably 6 hours or shorter.

### <Properties of Magnetic Paste>

The viscosity change of the magnetic paste according to the present embodiment with passage of time can be decreased. Specifically, the viscosity increasing rate of the magnetic paste with passage of time can be decreased. For example, when the magnetic paste is allowed to leave at a temperature of 25°C with the relative humidity of 60% for one week, the viscosity increasing rate of the magnetic paste can be preferably less than 1.7, more preferably less than 1.6, and especially preferably less than 1.5. The lower limit thereof is usually 1.0 or more, and may be 1.1 or more, or 1.2 or more. The viscosity increasing rate can be measured by the method described in Examples.

It is preferable that the magnetic paste according to the present embodiment has a low viscosity. The viscosity of the magnetic paste at 25°C is preferably 300 Pa·s or less, more preferably 250 Pa·s or less, and still more preferably 200 Pa·s or less, and is preferably 10 Pa·s or more, preferably 20 Pa·s or more, and more preferably 30 Pa·s or more. When the viscosity of the magnetic paste is less than or equal to the above-mentioned upper limit, the magnetic paste can smoothly enter into the hole that is formed in the core substrate. When the viscosity of the magnetic paste is more than or equal to the above-mentioned lower limit, it is possible to suppress the outflow of the magnetic paste from the through hole that is formed through the core substrate. Therefore, when the viscosity of the magnetic paste is within the above-mentioned range, the filling property of the magnetic paste can be excellent. The viscosity of the magnetic paste can be measured, for example, using an E-type viscometer ("RE-80U" manufactured by Toki Sangyo Co., Ltd., 3°×R9.7 cone, rotation speed of 5 rpm), specifically by the method as described in Examples to be described later.

The magnetic paste described above can be cured by heat. Therefore, the cured product of the magnetic paste can be obtained by thermally curing the magnetic paste. Usually, of the components included in the magnetic paste, volatile components such as water and (F) the organic solvent may be volatilized by heat during thermal curing, while nonvolatile components such as the components (A) to (E) are not volatilized by heat during thermal curing. Accordingly, the cured product of the magnetic paste may contain nonvolatile components in the magnetic paste or the reaction products thereof.

The cured product of the magnetic paste described above can have superior magnetic properties. The relative magnetic permeability of the cured product of the magnetic paste that is measured, for example, with the frequency of 50 MHz and the temperature of 25°C is preferably 4 or more, more preferably 6 or more, still more preferably 8 or more, and especially preferably 10 or more. There is no particular restriction in the upper limit thereof; so, the upper limit may be, for example, 40 or less. The relative magnetic permeability may be measured, for example, by the method described in Examples to be described later by using the cured product that is obtained by curing the magnetic paste at 190°C for 90 minutes.

The magnetic loss of the cured product of the magnetic paste that is measured, for example, with the frequency of 50 MHz and the temperature of 25°C is preferably 0.10 or less, more preferably 0.08 or less, still more preferably 0.06 or less, and especially preferably 0.05 or less. The lower limit thereof is ideally 0.00 or more, but usually 0.001 or more. The magnetic loss may be measured, for example, by the method described in Examples to be described later by using the cured product that is obtained by curing the magnetic paste at 190°C for 90 minutes.

From the viewpoint of utilizing the advantages described above, it is preferable to use the magnetic paste as the paste for filling the hole in the core substrate. For example, the magnetic paste enters into the hole to fill the hole with the magnetic paste. By curing the magnetic paste, the magnetic layer can be formed in the hole. In particular, the magnetic paste according to the present embodiment may be suitably used as the magnetic paste for filling the through hole that goes through the core substrate (i.e., magnetic paste for filling the through hole).

### <Circuit Board>

The circuit board according to one embodiment of the present embodiment includes the cured product of the magnetic paste described above. There is no particular restriction in the specific structure of the circuit board so far as the cured product of the magnetic paste is included therein. An example of this circuit board may include a circuit board comprising a core substrate having a hole formed therein and a magnetic layer filled in this hole. In the circuit board relating to this example, the magnetic layer contains the cured product of the magnetic paste, and preferably contains only the cured product of the magnetic paste.

The circuit board relating to the above example may be produced by the method including, for example,
(1) a step of filling a hole in a core substrate having a hole formed therein with the magnetic paste, and
(2) a step of curing the magnetic paste that has been filled in the hole to form a magnetic layer. This production method may further include
(3) a step of polishing a surface of the magnetic layer or a surface of the magnetic paste,
(4) a step of roughening the magnetic layer, and
(5) a step of forming a conductor layer on the surface of the magnetic layer. Usually, the steps (1) through (5) are carried out sequentially from the step (1) to the step (5), but the step (2) may be carried out after the step (3). In the following explanation, the example will be described in which a core substrate formed with a through hole as the hole that goes through the core substrate in the thickness direction is used.

### <Step (1)>

The step (1) usually includes a step of preparing a core substrate formed with a through hole. The core substrate may be prepared by purchasing from the market. Alternatively, the core substrate may be produced using a suitable material. Hereinafter, the production method of the core substrate according to one example will be described.

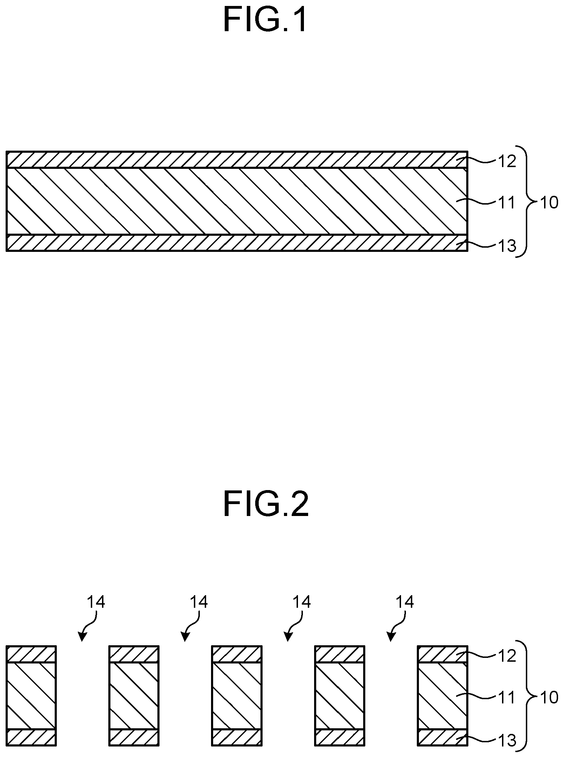

FIG. 1 is a schematic cross sectional view illustrating a core substrate 10 before being formed with a through hole in the production method of the circuit board according to one embodiment of the present invention. The step of preparing the core substrate 10 may include the step of preparing the core substrate 10 that is not formed with the through hole to be filled with the magnetic layer, as illustrated in FIG. 1. This core substrate 10 is the substrate before being formed with the through hole; here, this may be a plate member.

The core substrate 10 usually includes a supporting substrate 11. Illustrative examples of the supporting substrate 11 may include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both surfaces of the substrate. Here, the example is illustrated in which a metal layer 12 and a metal layer 13 are formed on both the surfaces of the supporting substrate 11. Illustrative examples of the metal layers 12 and 13 may include a layer formed of a metal such as copper. The metal layers 12 and 13 may be, for example, copper foil such as carrier-attached copper foil, or a metal layer formed of a material of the conductor layer to be described later.

FIG. 2 is a schematic cross sectional view illustrating the core substrate 10 formed with the through hole 14 in the production method of the circuit board according to one embodiment of the present invention. As illustrated in FIG. 2, the step of preparing the core substrate 10 may include a step of forming the through hole 14 in the core substrate 10. There is no particular restriction in the diameter of the through hole; the diameter may be, for example, in the range of 200 um to 800 um. The through hole 14 may be formed, for example, by drilling, laser irradiation, or plasma irradiation. The through hole 14 can be usually formed by forming a penetrating hole that goes through the core substrate 10. In a specific example, formation of the through hole 14 can be conducted by using a drilling machine that is commercially available. Illustrative examples of the commercially available drilling machine may include "ND-1S211" manufactured by Hitachi Via Mechanics, Ltd.

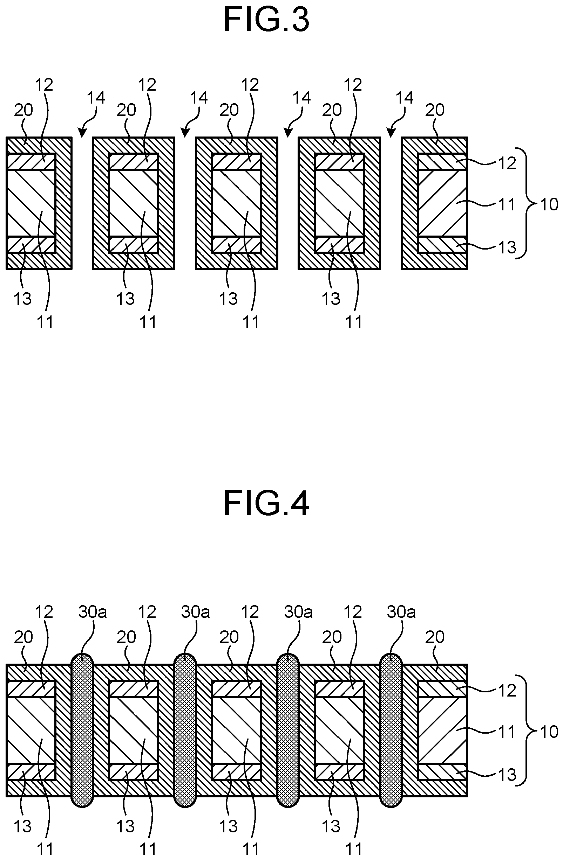

FIG. 3 is a schematic cross sectional view illustrating the core substrate 10 formed with a plated layer 20 in the through hole 14 in the production method of the circuit board according to one embodiment of the present invention. After the core substrate 10 is subjected to a roughening treatment as needed, the step of preparing the core substrate 10 may include a step of forming the plated layer 20, as illustrated in FIG. 3. The roughening treatment may be carried out with any of a dry roughening treatment and a wet roughening treatment. Illustrative examples of the dry roughening treatment may include a plasma treatment. Illustrative examples of the wet roughening treatment may include a method in which a swelling treatment by a swelling liquid, a roughening treatment by an oxidant, and a neutralizing treatment by a neutralizing solution are carried out in this order. The plated layer 20 may be formed by a plating method. The procedure to form the plated layer 20 by the plating method may be the same as the procedure in formation of the conductor layer at the step (5) to be described later. Here, the explanation will be made as to the example in which the plated layer 20 is formed inside the through hole 14, on the surface of the metal layer 12, and on the surface of the metal layer 13. In this example, the core substrate including the plated layer 20 is described with the same code "10" as the core substrate 10 before being formed with the plated layer 20.

FIG. 4 is a schematic cross sectional view illustrating the state of filling the through hole of the core substrate 10 with a magnetic paste 30a in the production method of the circuit board according to one embodiment of the present invention. As illustrated in FIG. 4, the step (1) includes, after the core substrate 10 formed with the through hole 14 is prepared, filling the through hole 14 in the core substrate 10 with the magnetic paste 30a. The filling may be conducted, for example, by a printing method. Illustrative examples of the printing method may include a method in which the magnetic paste 30a is printed into the through hole 14 via a squeegee, a method in which the magnetic paste 30a is printed via a cartridge, a method in which the magnetic paste 30a is printed by a mask printing, a roll coating method, and an inkjet method. Among these, the mask printing method that includes a mask printing is preferable, and the screen printing method in which a screen mask having a mask part that does not allow the magnetic paste to pass through and a mesh part that allows the magnetic paste to pass through is used is especially preferable.

It is preferable that the filling of the magnetic paste into the through hole 14 is carried out under a reduced pressure environment. Specifically, the pressure at the time of filling is preferably 1000 Pa or less, more preferably 500 Pa or less, and especially preferably 300 Pa or less. There is no particular restriction in the lower limit thereof; so, the lower limit may be 0 Pa or more, 10 Pa or more, or 20 Pa or more. When the magnetic paste is filled under a reduced pressure environment, it is possible to suppress the formation of a void in the magnetic paste that has been filled.

When the magnetic paste 30a is filled, an excess of the magnetic paste 30a usually protrudes to or adheres with the outside the through hole 14a. Therefore, the magnetic paste 30a may be present not only inside the through hole 14a but also outside the through hole 14a.

### <Step (2)>

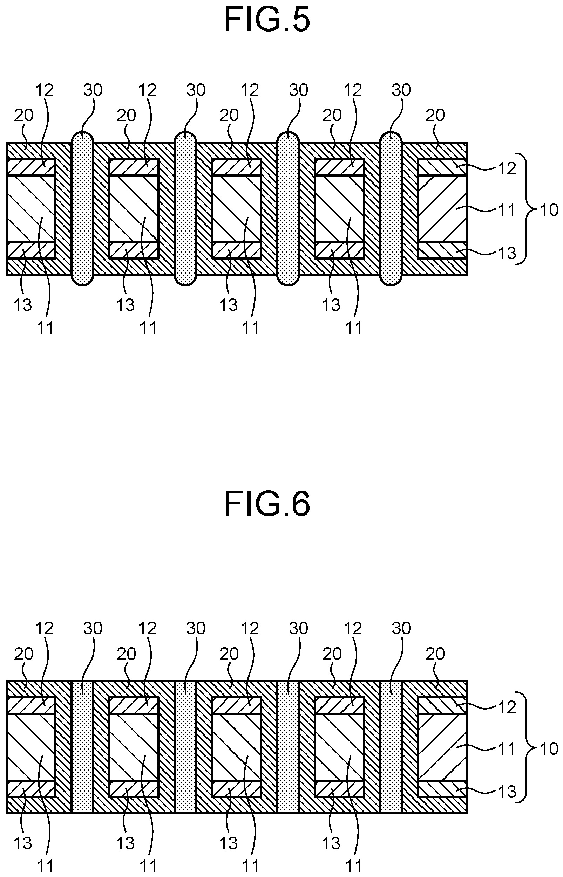

FIG. 5 is a schematic cross sectional view to explain the step (2) in the production method of the circuit board according to one embodiment of the present invention. The step (2) includes, after filling of the through hole 14 with the magnetic paste 30a, curing the magnetic paste 30a, as illustrated in FIG. 5. By curing the magnetic paste 30a, a magnetic layer 30 including the cured product of the magnetic paste 30a can be formed in the through hole 14.

The curing of the magnetic paste 30a is usually conducted by thermal curing. Conditions of the thermal curing of the magnetic paste 30a may be set as appropriate so far as the curing of the magnetic paste 30a proceeds. The curing temperature is preferably 120°C or higher, more preferably 130°C or higher, and still more preferably 150°C or higher, and is preferably 245°C or lower, more preferably 220°C or lower, and still more preferably 200°C or lower. The curing time is preferably 5 minutes or longer, more preferably 10 minutes or longer, and still more preferably 15 minutes or longer, and is preferably 120 minutes or shorter, more preferably 110 minutes or shorter, and still more preferably 100 minutes or shorter.

The curing degree of the cured product of the magnetic paste 30a that is obtained at the step (2) is preferably 80% or more, more preferably 85% or more, and still more preferably 90% or more. The curing degree can be measured by using, for example, a differential scanning calorimeter.

The production method of the circuit board may include, after filling the through hole 14 with the magnetic paste 30a and before curing the magnetic paste 30a, a step of heating the magnetic paste 30a at a temperature lower than the curing temperature (preliminary heating step). For example, prior to curing the magnetic paste 30a, the magnetic paste 30a may be preliminarily heated usually at a temperature of 50°C or higher and lower than 120°C (preferably 60°C or higher and 110°C or lower, more preferably 70°C or higher and 100°C or lower), usually for 5 minutes or longer (preferably for 5 minutes to 150 minutes, more preferably for 15 minutes to 120 minutes).

### <Step (3)>

FIG. 6 is a schematic cross sectional view to explain the step (3) in the production method of the circuit board according to one embodiment of the present invention. The step (3) includes polishing the excess magnetic layer 30 protruding from or adhering to the core substrate 10 as illustrated in FIG. 6. The excess magnetic layer 30 is removed by polishing, so that the surface of the magnetic layer 30 can be flattened.

As for the polishing method, the method with which the excess magnetic layer 30 that is protruding or adhering can be removed from the core substrate 10 may be used. Illustrative examples of the polishing method as described above may include a buff polishing method, a belt polishing method, and a ceramic polishing method. Illustrative examples of the buff polishing equipment that is commercially available may include "NT-700IM" manufactured by Ishiihyoki Co., Ltd.

From the viewpoint of enhancing the adhesion with the conductor layer, the arithmetic average roughness (Ra) of the polished surface of the magnetic layer 30 (after thermal curing of the cured product layer) is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) can be measured, for example, by using a non-contact type surface roughness meter.

In the case that the step (3) is carried out after the step (2), the magnetic layer 30 may be subjected to a heat treatment after the step (2) and before the step (3), in order to further increase the curing degree of the cured product included in the magnetic layer 30. As for the temperature at this heat treatment, the aforementioned curing temperature may be applied. Specifically, the heat treatment temperature is preferably 120°C or higher, more preferably 130°C or higher, and still more preferably 150°C or higher, and is preferably 245°C or lower, more preferably 220°C or lower, and still more preferably 200°C or lower. The heat treatment period is preferably 5 minutes or longer, more preferably 10 minutes or longer, and still more preferably 15 minutes or longer, and is preferably 90 minutes or shorter, more preferably 70 minutes or shorter, and still more preferably 60 minutes or shorter.

When the step (3) is carried out before the step (2), a preliminary heating treatment of heating the magnetic paste at a temperature lower than the curing temperature of the magnetic paste may be carried out before step (3). The temperature at the preliminary heating treatment is preferably 100°C or higher, more preferably 110°C or higher, and still more preferably 120°C or higher, and is preferably 245°C or lower, more preferably 220°C or lower, and still more preferably 200°C or lower. The heat treatment period is preferably 5 minutes or longer, more preferably 10 minutes or longer, and still more preferably 15 minutes or longer, and is preferably 90 minutes or shorter, more preferably 70 minutes or shorter, and still more preferably 60 minutes or shorter.

### <Step (4)>

The step (4) includes subjecting the magnetic layer 30 to a roughening treatment (desmear treatment). Usually, the roughening treatment is applied to the polished surface of the magnetic layer. In the step (4), not only the polished surface of the magnetic layer but also the surface of the core substrate 10 may be subjected to the roughening treatment.

There is no particular restriction in the procedure and condition of the roughening treatment; for example, the procedure and condition that are used in the production method of a multilayer printed wiring board may be used. In a specific example, the roughening treatment may be carried out by the method including a swelling treatment with a swelling liquid, a roughening treatment with an oxidant, and a neutralizing treatment with a neutralizing solution in this order.

Illustrative examples of the swelling liquid that can be used in the swelling treatment may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd.

The swelling treatment with the swelling liquid may be carried out, for example, by immersing the magnetic layer 30 into the swelling liquid at the temperature of 30°C to 90°C for the period of 1 minute to 20 minutes. From the viewpoint of suppressing the swelling of the resin that constitutes the magnetic layer 30 to a suitable level, it is preferable that the magnetic layer 30 is immersed into the swelling liquid at the temperature of 40°C to 80°C for the period of 5 minutes to 15 minutes.

Illustrative examples of the oxidant that can be used in the roughening treatment may include an alkaline permanganate solution having potassium permanganate or sodium permanganate dissolved into a sodium hydroxide aqueous solution. The roughening treatment using the oxidant such as the alkaline permanganate solution is preferably carried out by immersing the magnetic layer 30 into the oxidant solution heated at 60°C to 80°C for the period of 10 minutes to 30 minutes. The concentration of the permanganate salt in the alkaline permanganate solution is preferably in the range of 5% by mass to 10% by mass. Illustrative examples of the oxidant that is commercially available may include alkaline permanganate solutions such as "Concentrate Compact P" and "Dosing Solution Securiganth P", both of which are manufactured by Atotech Japan, Co., Ltd.

The neutralizing solution that may be used in the neutralizing treatment is preferably an acidic aqueous solution. A commercially available neutralizing solution is, for example, "Reduction Solution Securigance P" manufactured by Atotech Japan Co., Ltd. The neutralizing treatment with the neutralizing solution can be carried out by immersing the treated surface, which has been subjected to the roughening treatment using the oxidant solution, into the neutralizing solution at the temperature range of 30°C to 80°C for the period of 5 minutes to 30 minutes. From the viewpoint of workability, it is preferable to immerse the magnetic layer 30, which has been subjected to the roughening treatment using the oxidant solution, into the neutralizing solution at the temperature range of 40°C to 70°C for the period of 5 minutes to 20 minutes.

From a viewpoint of improving the adhesion with the conductor layer, the arithmetic average roughness (Ra) of the surface of the magnetic layer 30 after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) can be measured, for example, by using a non-contact type surface roughness meter.

### <Step (5)>

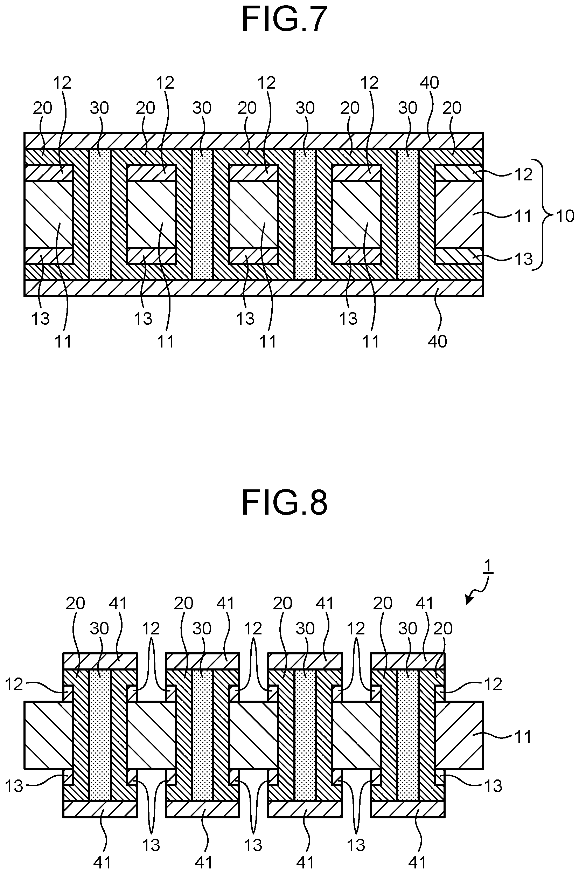

FIG. 7 is a schematic cross sectional view to explain the step (5) in the method for producing the circuit board according to one embodiment of the present invention. The step (5) includes forming a conductor layer 40 on the surface of the magnetic layer 30, as illustrated in FIG. 7. When the production method of the circuit board includes the step (3), the conductor layer 40 is usually formed on the polished surface of the magnetic layer 30 at the step (5). When the production method of the circuit board includes the step (4), the conductor layer 40 is usually formed on the roughened surface of the magnetic layer 30 at the step (5). In the present embodiment, the example is illustrated in which the conductor layer 40 is formed not only on the surface of the magnetic layer 30 but also on the surface therearound (for example, the surface of the core substrate 10 and the surface of the plated layer 20). In FIG. 7, the example that the conductor layer 40 is formed on both sides of the core substrate 10 is illustrated; but the conductor layer 40 may be formed on only one side of the core substrate 10.

FIG. 8 is a schematic cross sectional view to explain the step (5) in the method for producing the circuit board according to one embodiment of the present invention. As illustrated in FIG. 8, after the conductor layer 40 is formed, the step (5) may include removing a part of the conductor layer 40, a first metal layer 12, a second metal layer 13, and the plated layer 20 to form a patterned conductor layer 41 by a treatment such as etching.

Illustrative examples of the method for forming the conductor layer 40 may include a plating method, a sputtering method, and a vapor deposition method. Among these, the plating method is preferable. In a preferable embodiment, the surface of the magnetic layer 30 (and the core substrate 10, as needed) is plated with a suitable method such as a semi-additive method or a full additive method, so that the patterned conductor layer 41 having an intended wiring pattern may be formed. Illustrative examples of the material of the conductor layer 40 may include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from the viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as the nickel-chromium alloy. Copper is still more preferably used.

Here, the example of the method to form the patterned conductor layer 41 will be explained in detail. A plated seed layer is formed on the surface of the magnetic layer 30 by an electroless plating. Next, after a mask pattern is formed as needed, an electroplated layer is formed on the resulting plated seed layer by an electroplating. Then, as needed, the mask pattern is removed, and then further an unnecessary plated seed layer is removed by a treatment such as etching, so that the patterned conductor layer 41 having an intended wiring pattern can be formed. After the patterned conductor layer 41 is formed, in order to improve the adhesion strength of the patterned conductor layer 41, an annealing treatment may be carried out, as needed. The annealing treatment can be carried out, for example, by heating at the temperature range of 150°C to 200°C for the period of 20 minutes to 90 minutes.

From the viewpoint of thinning, the thickness of the patterned conductor layer 41 is preferably 70 µm or less, more preferably 60 µm or less, still more preferably 50 µm or less, even still more preferably 40 um or less, and especially preferably 30 um or less, 20 um or less, 15 um or less, or 10 µm or less. The lower limit thereof is preferably 1 µm or more, more preferably 3 um or more, and still more preferably 5 µm or more.

By the method described above, the circuit board 1 including the magnetic layer 30 that contains the cured product of the magnetic paste can be obtained. The magnetic layer 30 is obtained by curing the magnetic paste 30a, and thus, the magnetic layer 30 includes the cured product of the magnetic paste 30a. Therefore, the magnetic layer 30 can contain more amount of (A) the magnetic powder having a small particle diameter, so that superior magnetic properties can be obtained. In addition, the magnetic paste 30a, which is the material of the magnetic layer 30, can suppress the viscosity change with passage of time while (A) the magnetic powder having a small particle diameter is included therein. Therefore, the adjustment frequency of the filling conditions of the magnetic paste 30a into the through hole 14 in the step (1) can be decreased, thereby enabling efficient manufacturing of the circuit board 1.

### <Inductor Substrate>

The inductor component according to one embodiment of the present invention includes the circuit board described above. The inductor component usually has an inductor pattern that is formed of a conductor at least in part of the circumference of the magnetic layer. As for the inductor component, for example, the one that is described in Japanese Patent Application Laid-open No. 2016-197624 may be used.

The inductor component may be used as the wiring board on which an electronic part such as a semiconductor chip is mounted, and may also be used as a (multilayered) printed wiring board that uses this wiring board as an inner layer substrate. In addition, this may be used as a chip inductor component obtained by dicing the wiring board, and may also be used as a printed wiring board that is surface-mounted with the chip inductor component.

By using this wiring board, semiconductor devices with various embodiments may be produced. The semiconductor device including the wiring board may be suitably used in electric products (for example, a computer, a mobile phone, a digital camera, and a television), and vehicles (for example, a motor bike, an automobile, a train, a marine ship, and an airplane).

### <EXAMPLES>

Hereinafter, the present invention will be specifically described by Examples. The present invention is not limited to these Examples. In the description below, "part" and "%" that describe quantity mean "part by mass" and "% by mass", respectively, unless otherwise specifically mentioned. Unless otherwise specifically mentioned, the following operations were performed at normal temperature and normal pressure (25°C and 1 atm). In addition, the volume content (% by volume) was determined by calculation using a mass and a specific gravity.

### <Example 1: Preparation of Magnetic Paste 1>

15 parts by mass of the epoxy resin ("ZX-1059", mixture of bisphenol A type epoxy resin and bisphenol F type epoxy resin, epoxy equivalent of about 165 g/eq., manufactured by Nippon Steel Chemical & Material Co., Ltd.), 5 parts by mass of the epoxy resin ("ZX-1658GS", cyclic aliphatic diglycidyl ether, reactive diluent, epoxy equivalent of 135 g/eq., manufactured by Nippon Steel Chemical & Material Co., Ltd.)), 1.1 parts by mass of the dispersant ("C-2093I", acidic dispersant for nanoparticles, manufactured by NOF Corp.), 1 part by mass of the curing accelerator ("2MZA-PW", imidazole type epoxy resin curing accelerator, manufactured by Shikoku Chemicals Corp.), and 180 parts by mass of the magnetic powder ("AW2-08 PF3F", Fe-Cr-Si type alloy (amorphous), average particle diameter of 3.0 µm, specific surface area of 0.66 m²/g, specific gravity of 7.11 g/cm3, manufactured by Epson Atmix Corp.) were mixed and stirred using a stirrer (Awatori Neritarou ARE-310, manufactured by Thinky Corp.) at 2000 rpm for 1 minute to obtain a pasty composition.

A vacuum desiccator (Vacuum Desiccator VM, manufactured by AS ONE Corp.) was prepared, and the absolute pressure inside the vacuum desiccator was confirmed to be 350 Pa by using an absolute pressure gauge (Digital Vacuum Gauge Pilot PLUS, manufactured by Asada Co., Ltd.). The above-mentioned pasty composition was dried under a reduced pressure in the vacuum desiccator for 60 minutes to obtain Magnetic Paste 1.

### <Example 2: Preparation of Magnetic Paste 2>

In place of 1.1 parts by mass of the dispersant ("C-2093I", acidic dispersant for nanoparticles, manufactured by NOF Corp.), 1.1 parts by mass of the dispersant ("DA-375", polyether phosphate ester, manufactured by Kusumoto Chemicals, Ltd.) was used. In place of 180 parts by mass of the magnetic powder ("AW2-08 PF3F", Fe-Cr-Si type alloy (amorphous), average particle diameter of 3.0 µm, specific surface area of 0.66 m²/g, specific gravity of 7.11 g/cm3, manufactured by Epson Atmix Corp.), 180 parts by mass of the magnetic powder ("MA-RCO-5", Fe-Ni type alloy, average particle diameter of 3.0 µm, specific surface area of 0.45 m²/g, specific gravity of 8.0 g/cm³, manufactured by Dowa Electronics Materials Co., Ltd.) was used. Magnetic Paste 2 was prepared in the same way as in Example 1 except for the above-mentioned matters.

### <Example 3: Preparation of Magnetic Paste 3>

In place of 1.1 parts by mass of the dispersant ("C-2093I", acidic dispersant for nanoparticles, manufactured by NOF Corp.), 1.1 parts by mass of the dispersant ("SC-1015F", multifunctional comb-type functional polymer having a polyoxyalkylene chain, manufactured by NOF Corp.) was used. In place of 180 parts by mass of the magnetic powder ("AW2-08 PF3F", Fe-Cr-Si type alloy (amorphous), average particle diameter of 3.0 µm, specific surface area of 0.66 m²/g, specific gravity of 7.11 g/cm3, manufactured by Epson Atmix Corp.), 110 parts by mass of the magnetic powder ("M05S", Fe-Mn type ferrite, average particle diameter of 3.0 µm, specific surface area of 0.68 m²/g, specific gravity of 5.1 g/cm3, manufactured by Powdertech Co., Ltd.) was used. Magnetic Paste 3 was prepared in the same way as in Example 1 except for the above-mentioned matters.

### <Example 4: Preparation of Magnetic Paste 4>

In place of 1.1 parts by mass of the dispersant ("C-2093I", acidic dispersant for nanoparticles, manufactured by NOF Corp.), 1.1 parts by mass of the dispersant ("PB881", polyamine type dispersant, manufactured by Ajinomoto Fine-Techno Co., Inc.) was used. In place of 180 parts by mass of the magnetic powder ("AW2-08 PF3F", Fe-Cr-Si type alloy (amorphous), average particle diameter of 3.0 µm, specific surface area of 0.66 m²/g, specific gravity of 7.11 g/cm3, manufactured by Epson Atmix Corp.), 150 parts by mass of the magnetic powder ("MZ05S", Fe-Mn-Zn type ferrite, average particle diameter of 3.0 µm, specific surface area 0.58 m²/g, specific gravity of 5.1 g/cm³, manufactured by Powdertech Co., Ltd.) was used. Magnetic Paste 4 was prepared in the same way as in Example 1 except for the above-mentioned matters.

### <Example 5: Preparation of Magnetic Paste 5>

Magnetic Paste 5 was prepared in the same way as in Example 4, except that the absolute pressure in the vacuum desiccator was changed from 350 Pa to 750 Pa.

### <Example 6: Preparation of Magnetic Paste 6>

Magnetic Paste 6 was prepared in the same way as in Example 4, except that 1.1 parts by mass of the dispersant ("PB881", polyamine type dispersant, manufactured by Ajinomoto Fine-Techno Co., Inc.) was not used.

### <Comparative Example 1: Preparation of Magnetic Paste 7>

15 parts by mass of the epoxy resin ("ZX-1059", mixture of bisphenol A type epoxy resin and bisphenol F type epoxy resin, epoxy equivalent of about 165 g/eq., manufactured by Nippon Steel Chemical & Material Co., Ltd.), 5 parts by mass of the epoxy resin ("ZX-1658GS", cyclic aliphatic diglycidyl ether, reactive diluent, epoxy equivalent of 135 g/eq., manufactured by Nippon Steel Chemical & Material Co., Ltd.), 1.1 parts by mass of the dispersant ("SC-1015F", acidic dispersant for nanoparticles, manufactured by NOF Corp.), 1 part by mass of the curing accelerator ("2MZA-PW", imidazole type epoxy resin curing accelerator, manufactured by Shikoku Chemicals Corp.), and 110 parts by mass of the magnetic powder ("M05S", Fe-Mn type ferrite, average particle diameter of 3 µm, specific surface area of 0.68 m²/g, specific gravity of 5.1 g/cm3, manufactured by Powdertech Co., Ltd.) were mixed and stirred using a stirrer (Awatori Neritarou ARE-310, manufactured by Thinky Corp.) at 2000 rpm for 1 minute to obtain a pasty composition.

A vacuum desiccator (Vacuum Desiccator VM, manufactured by AS ONE Corp.) was prepared, and the absolute pressure inside the vacuum desiccator was confirmed to be 4000 Pa by using an absolute pressure gauge (Digital Vacuum Gauge Pilot PLUS, manufactured by Asada Co., Ltd.). The resulting pasty composition was dried under a reduced pressure in the vacuum desiccator for 60 minutes to obtain Magnetic Paste 7.

### <Comparative Example 2: Preparation of Magnetic Paste 8>

In place of 1.1 parts by mass of the dispersant ("SC-1015F", multifunctional comb-type functional polymer having a polyoxyalkylene chain, manufactured by NOF Corp.), 1.1 parts by mass of the dispersant ("PB881", polyamine type dispersant, manufactured by Ajinomoto Fine-Techno Co., Inc.) was used. In place of 110 parts by mass of the magnetic powder ("M05S", Fe-Mn type ferrite, average particle diameter of 3.0 µm, specific surface area of 0.68 m²/g, specific gravity of 5.1 g/cm3, manufactured by Powdertech Co., Ltd.), 150 parts by mass of the magnetic powder ("MZ05S", Fe-Mn-Zn type ferrite, average particle diameter of 3.0 µm, specific surface area of 0.58 m²/g, specific gravity of 5.1 g/cm³, manufactured by Powdertech Co., Ltd.) was used. Magnetic Paste 8 was prepared in the same way as in Comparative Example 1 except for the above-mentioned matters.

### <Measurement of Water Content in Magnetic Paste>

After 2.5 g to 3.0 g of the magnetic paste was taken out, the water content in this magnetic paste was measured using a Karl Fischer water measuring instrument ("Trace Amount Water Analyzer CA-200", manufactured by Mitsubishi Chemical Analytec Co., Ltd,) using the coulometric titration method. The instrument consists of a glass container that is capable of holding and heating the sample, and a titration system containing a reaction solution that titrates the water that is vaporized when the sample is heated. The vaporized water is transferred from the glass container to the reaction solution in the titration system by flowing nitrogen at the flow rate of 250±25 ml/min. In a glass container replaced with a nitrogen atmosphere (water vapor content of less than 0.1 ppm), the sample was placed. The amount of water that was vaporized under the condition of 130°C is measured, and the water content in the magnetic paste (initial water content) was calculated.

### <Measurement of Initial Viscosity of Magnetic Paste>

With keeping the temperature of the magnetic paste at 25±2°C, the viscosity η₀ (initial viscosity) of the magnetic paste was measured using an E-type viscometer ("RE-80U" manufactured by Toki Sangyo Co., Ltd., 3°×R9.7 cone, rotation speed of 5 rpm) at 25°C.

### <Measurement of Viscosity of Magnetic Paste After 7 Days>

With keeping the temperature of the magnetic paste at 25±2°C, the magnetic paste was left in an environment of 60% relative humidity for one week. Then, using an E-type viscometer ("RE-80U" manufactured by Toki Sangyo Co., Ltd., 3°×R9.7 cone, rotation speed 5 rpm), the viscosity η₇ (viscosity after storage) of the magnetic paste was measured at 25°C.

### <Calculation of Viscosity Increasing Rate>

By dividing the viscosity η₇ of the magnetic paste after 7 days by the initial viscosity η₀, a value (η₇/η₀) was calculated as the viscosity increasing rate. On the basis of the calculated viscosity increasing rate, the storage stability of the magnetic paste was evaluated from the viewpoint of printing stability in accordance with the following criteria.
O: Viscosity increasing rate is less than 1.7.
X: Viscosity increasing rate is 1.7 or more.

### <Method for Measuring Magnetic Properties>

A polyethylene terephthalate (PET) film ("PET501010", manufactured by Lintech Corp., thickness of 50 um) having a release surface that was treated with a silicone type release agent was prepared as a support. The magnetic paste was applied uniformly with a doctor blade onto the release surface of the PET film. Then, the magnetic paste was cured by heating at 190°C for 90 minutes to obtain a cured product in the form of a sheet. After the support was removed, the cured product was cut to obtain an evaluation sample having a width of 5 mm and a length of 18 mm. The relative magnetic permeability (µ') and the magnetic loss (µ'') of the evaluation sample were measured at 25°C by the 3-turn coil method at the measurement frequency of 50 MHz by using Agilent Technologies ("HP8362B" manufactured by Agilent Technologies, Inc.). The magnetic loss was calculated from the formula [tanδ=µ"/µ'].

### <Results of Examples and Comparative Examples>

The results of Examples and Comparative Examples are summarized in Tables below.

**[Table 1]**

| **[Table 1. Results of Exam ples**] | | | | | | |
|---|---|---|---|---|---|---|
| Example | 1 | 2 | 3 | 4 | 5 | 6 |
| (A) AW-08PF3F | 180 | | | | | |
| (A) MA-RCO-5 | | 180 | | | | |
| (A) MOSS | | | 110 | | | |
| (A) MZ05S | | | | 150 | 150 | 150 |
| (B) ZX-1059 | 15 | 15 | 15 | 15 | 15 | 15 |
| (B) ZX-1658GS | 5 | 5 | 5 | 5 | 5 | 5 |
| (C) 2MZA-PW | 1 | 1 | 1 | 1 | 1 | 1 |
| (D) C-20931 | 1.1 | | | | | |
| (D) DA-375 | | 1.1 | | | | |
| (D) SC-1015F | | | 1.1 | | | |
| (D) PB881 | | | | 1.1 | 1.1 | |
| Total amount (parts by mass) | 202.1 | 202.1 | 132.1 | 172.1 | 172.1 | 171 |
| Magnetic powder (% by volume) | 56 | 53 | 52 | 59 | 59 | 61 |
| Drying pressure [Pa] | 350 | 350 | 350 | 350 | 750 | 350 |
| Initial water content [ppm] | 714 | 915 | 848 | 661 | 888 | 613 |
| Initial viscosity η₀ [Pa·s] | 83 | 97 | 85 | 108 | 104 | 193 |
| Viscosity after storage η₇ [Pa·s] | 111 | 148 | 122 | 165 | 165 | 273 |
| Viscosity increasing rate η₇/η₀ | 1.3 | 1.5 | 1.4 | 1.5 | 1.6 | 1.4 |
| Storage stability | O | O | O | O | O | O |
| Relative magnetic permeability | 7.5 | 11.2 | 4.4 | 9.7 | 9.7 | 9.7 |
| Magnetic loss | 0.03 | 0.02 | 0.01 | 0.09 | 0.09 | 0.09 |

**[Table 2]**

| **[Table 2. Results of Comparative Examples]** | | |
|---|---|---|
| Comparative Example | 1 | 2 |
| (A) AW-08PF3F | | |
| (A) MA-RCO-5 | | |
| (A) MOSS | 110 | |
| (A) MZ05S | | 150 |
| (B) ZX-1059 | 15 | 15 |
| (B) ZX-1658GS | 5 | 5 |
| (C) 2MZA-PW | 1 | 1 |
| (D) C-20931 | | |
| (D) DA-375 | | |
| (D) SC-1015F | 1.1 | |
| (D) PB881 | | 1.1 |
| Total amount (parts by mass) | 132.1 | 172.1 |
| Magnetic powder (% by volume) | 52 | 59 |
| Drying pressure [Pa] | 4000 | 4000 |
| Initial water content [ppm] | 1055 | 1010 |
| Initial viscosity η₀ [Pa·s] | 66 | 91 |
| Viscosity after storage η₇ [Pa·s] | 116 | 236 |
| Viscosity increasing rate η₇/η₀ | 1.8 | 2.6 |
| Storage stability | X | X |
| Relative magnetic permeability | 4.4 | 0.7 |
| Magnetic loss | 0.01 | 0.09 |

### <Reference Example 1: Preparation of Magnetic Paste 9>

15 parts by mass of the epoxy resin ("ZX-1059", mixture of bisphenol A type epoxy resin and bisphenol F type epoxy resin, manufactured by Nippon Steel Chemical & Material Co., Ltd.), 5 parts by mass of the epoxy resin ("ZX-1658GS", cyclic aliphatic Diglycidyl ether, manufactured by Nippon Steel Chemical & Material Co., Ltd.), 1.1 parts by mass of the dispersant ("C-2093I", acidic dispersant for nanoparticles, manufactured by NOF Corp.), 1 part by mass of the curing accelerator ("2MZA-PW", imidazole type epoxy resin curing accelerator, manufactured by Shikoku Chemicals Corp.), and 110 parts by mass of the magnetic powder ("M05S", Fe-Mn type ferrite, average particle diameter of 3 µm, manufactured by Powdertech Co., Ltd) were mixed and stirred using a stirrer (Awatori Neritarou ARE-310, manufactured by Thinky Corp.) at 2000 rpm for 1 minute to prepare Magnetic Paste 9.

### <Reference Example 2: Preparation of Magnetic Paste 10>

Magnetic Paste 10 was prepared in the same way as in Reference Example 1, except that 110 parts by mass of the magnetic powder ("MOSS 50 µm", Fe-Mn type ferrite, average particle diameter of 50.0 µm, manufactured by Powdertech Co., Ltd.) was used in place of 110 parts by mass of the magnetic powder ("M05S", Fe-Mn type ferrite, average particle diameter of 3.0 µm, manufactured by Powdertech Co., Ltd.).

### <Results of Reference Examples>

The magnetic pastes obtained in Reference Examples 1 and 2 were evaluated by the method described earlier. The results of Reference Examples are summarized in Table below.

**[Table 3]**

| **[Table 3. Results of Reference Examples]** | | |
|---|---|---|
| Reference Example | 1 | 2 |
| (A) MOSS 3µm | 110 | |
| (A') MOSS 50µm | | 110 |
| (B) ZX-1059 | 15 | 15 |
| (B) ZX-1658GS | 5 | 5 |
| (C) 2MZA-PW | 1 | 1 |
| (D) C-2093I | 1.1 | 1.1 |
| Total amount (parts bv mass) | 132.1 | 132.1 |
| Magnetic powder (% bv volume) | 52 | 52 |
| Stirring (2000 rpm Imin) | Conducted | Conducted |
| Vacuum drying | Not conducted | Not conducted |
| Initial water content [ppm] | 1078 | 668 |
| Initial viscosity η₀ [Pa·s] | 64 | 78 |
| Viscosity after storage η₇ [Pa·s] | 117 | 76 |
| Viscosity increasing rate η₇/η₀ | 1.8 | 1.0 |
| Storage stability | X | O |

### <Discussion>

From the results of Reference Example 1, it was confirmed that the magnetic paste containing the magnetic powder having an average particle diameter of 10 µm or less had a large increase in the viscosity of the magnetic paste with passage of time. From the results of Reference Example 2, it was confirmed that the magnetic paste containing the magnetic powder having an average particle diameter of larger than 10 um had a small increase in its viscosity with passage of time. The magnetic paste of Reference Example 1 and the magnetic paste of Reference Example 2 have the same composition except for the average particle diameter of the magnetic powder. Therefore, from the comparison between Reference Examples 1 and 2, it was confirmed that the problem of the viscosity increase with passage of time was caused specifically by the use of the magnetic powder having a small average particle diameter, this use being in line with the recent trend toward a higher performance in an inductor component.

### Reference Signs List

- 1: Circuit board
- 10: Core substrate
- 11: Supporting substrate
- 12: Metal layer
- 13: Metal layer
- 14: Through hole
- 20: Plated layer
- 30a: Magnetic paste
- 30: Magnetic layer
- 40: Conductor layer
- 41: Patterned conductor layer

## Claims

1. A magnetic paste comprising:
(A) a magnetic powder; and
(B) a thermosetting resin, wherein
(A) the magnetic powder has an average particle diameter of 10 µm or less, and
a water content in the magnetic paste is 1000 ppm or less.

2. The magnetic paste according to claim 1, wherein an amount of (A) the magnetic powder relative to 100% by volume of nonvolatile components in the magnetic paste is 30% by volume or more.

3. The magnetic paste according to claim 1, wherein (B) the thermosetting resin comprises (B-1) an epoxy resin.

4. The magnetic paste according to claim 3, wherein an amount of (B-1) the epoxy resin relative to 100% by mass of resin components in the magnetic paste is 30% by mass or more.

5. The magnetic paste according to claim 1, comprising (C) a curing accelerator.

6. The magnetic paste according to claim 1, wherein the magnetic paste is for filling a through hole.

7. A cured product of the magnetic paste according to any one of claims 1 to 6.

8. A circuit board comprising a cured product of the magnetic paste according to any one of claims 1 to 6.

9. A circuit board comprising:
a substrate formed with a through hole; and
a magnetic layer that is filled in the through hole, wherein
the magnetic layer comprises a cured product of the magnetic paste according to any one of claims 1 to 6.

10. An inductor component comprising the circuit board according to claim 8 or 9.

11. A production method of a circuit board, the production method comprising:
a step of filling a hole in a substrate having the hole formed therein with the magnetic paste according to any one of claims 1 to 6; and
a step of curing the magnetic paste that has been filled in the hole.

12. A production method of the magnetic paste according to any one of claims 1 to 6, the production method comprising:
a step of mixing (A) a magnetic powder and (B) a thermosetting resin to obtain a pasty composition; and
a step of vacuum drying the pasty composition at an absolute pressure of 800 Pa or less.
